(19) **Europäisches Patentamt**
**European Patent Office**
**Office européen des brevets**

(11) **EP 3 541 971 B1**

(12) **FASCICULE DE BREVET EUROPEEN**

(45) Date de publication et mention de la délivrance du brevet:
**01.04.2020 Bulletin 2020/14**

(21) Numéro de dépôt: **17822395.4**

(22) Date de dépôt: **08.12.2017**

(51) Int Cl.:
*C23C 16/27* (2006.01)    *C23C 16/511* (2006.01)
*H01J 37/32* (2006.01)

(86) Numéro de dépôt international:
**PCT/FR2017/053482**

(87) Numéro de publication internationale:
**WO 2018/104689 (14.06.2018 Gazette 2018/24)**

(54) **RÉACTEUR MODULAIRE POUR LE DÉPÔT ASSISTÉ PAR PLASMA MICROONDE ET PROCÉDÉ DE SYNTHÈSE DE DIAMANT CORRESPONDANT**

**MODULARER REAKTOR FÜR MIKROWELLENPLASMAUNTERSTÜTZTE ABSCHEIDUNG UND ENTSPRECHENDES DIAMANTSYNTHESEVERFAHREN**

**MODULAR REACTOR FOR MICROWAVE PLASMA-ASSISTED DEPOSITION AND CORRESPONDING DIAMOND SYNTHESIS METHOD**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.12.2016 FR 1670746**

(43) Date de publication de la demande:
**25.09.2019 Bulletin 2019/39**

(73) Titulaire: **Diam Concept**
**75016 Paris (FR)**

(72) Inventeurs:
• **GICQUEL, Alix**
 **14360 Trouville sur mer (FR)**
• **DES PORTES, François**
 **75116 Paris (FR)**

(74) Mandataire: **A.P.I. Conseil**
**Immeuble Newton**
**4 rue Jules Ferry**
**64000 Pau (FR)**

(56) Documents cités:
**WO-A1-2015/071484    GB-A- 2 486 783**
**GB-A- 2 497 661**

• SU J J ET AL: "A dome-shaped cavity type microwave plasma chemical vapor deposition reactor for diamond films deposition", VACUUM, vol. 107, avril 2014 (2014-04), pages 51-55, XP028865882, ISSN: 0042-207X, DOI: 10.1016/J.VACUUM.2014.04.002
• AN K ET AL: "Microwave plasma reactor with conical-reflector for diamond deposition", VACUUM, vol. 117, avril 2015 (2015-04), pages 112-120, XP029173040, ISSN: 0042-207X, DOI: 10.1016/J.VACUUM.2015.04.023

**Description**

L'invention concerne le domaine de la synthèse de diamant par dépôt assisté par plasma microonde. L'invention porte sur un réacteur modulaire pour le dépôt assisté par plasma microonde comportant au moins trois éléments de modulation permettant une adaptation de façon à optimiser les configurations du réacteur aux différents objectifs des croissances réalisées et aux besoins de maintenance de tels réacteurs. L'invention porte également sur un procédé de synthèse de diamant par un tel réacteur.

**[Art antérieur]**

Grâce à ses propriétés mécanique, optique, thermique, électronique et chimique, le diamant synthétique est de plus en plus utilisé dans l'industrie.
Ainsi, il est retrouvé comme constituant essentiel de nombreux produits tels que les fenêtres optiques, les outils de coupe, les détecteurs de rayonnement, électrodes, mais également en électronique, comme drain thermique et est très prometteur pour des applications en électronique de puissance.
Il existe aujourd'hui une tendance à l'augmentation de la taille des réacteurs de dépôt assisté par plasma microonde de façon à augmenter la dimension des couches polycristallines produites ou bien le nombre de monocristaux de diamant pouvant être produits en une expérimentation et cela notamment afin de réaliser des économies d'échelle.
L'Homme du métier connaît l'influence et l'interdépendance de nombreuses variables pour ajuster les conditions de croissance aux objectifs poursuivis. Pendant les phases de dépôt et de croissance des couches de diamant, il est connu de l'Homme du métier que des variables et paramètres tels que la pression, la puissance, la température du ou des substrats, la concentration et la composition des gaz injectés, leur distribution au sein du réacteur, la propagation électromagnétique, la position et la dimension du ou des substrats, leur distance par rapport au plasma produisent des effets sur la croissance de couches de diamant.
De même, il est connu de l'Homme du métier que les caractéristiques physiques du réacteur, son design, la forme de sa ou ses cavités et les matériaux qui le constituent, l'emplacement, le design et le dimensionnement des systèmes d'injection des micro-ondes et des gaz ou des systèmes de refroidissement influent, en tant que tels, sur les caractéristiques des couches de diamant, mais également sur les paramètres préalablement cités (Kobashi et al. Diamond and Related Materials 12, 2003, 233-240; Ando Y et al. Diamond and Related Materials, 11, 2002, 596-600; Mesbahi et al. Journal of Applied Physics 2013, vol 46, n°38, 2013). Ainsi de nombreux articles mentionnent la complexité des procédés de dépôt de diamant au sein des réacteurs à plasma en raison de la multiplicité des paramètres à prendre en compte et la nécessité de recourir à des modèles de simulation simplifiant les données et réduisant les variables (Gicquel et al. Diamond and Related Materials, 1994, vol3, Issue 4-6, 581; Gicquel et al. Current Applied Physics, vol1 Issue 6 , 479 , 2001; Hassouni et al. Journal of Applied Physics, vol 86 Issue 1, pages: 134- 1999; Hassouni et al. Journal of Physics D Journal of Applied Physics, vol 43 Issue: 15, 2010; Goodwin et al. J. Appl. Phys. 74(11) 1993; Kobashi et al. 2003 Diamond and Related Materials, 12, 233-240 ; Mankelevich et al., Journal Of Applied Physics, 104, 2008).
Les facteurs contribuant aux dépôts et à la croissance de couches de diamant, en raison de leur nombre et de leur complexité, sont donc aujourd'hui encore uniquement partiellement maîtrisés par l'Homme du métier, qui se doit de recourir à des modèles simplificateurs, bien que pouvant être évolutifs, pour à la fois conceptualiser et construire les réacteurs et conduire les opérations.
Ce recours à la modélisation se justifie également par le fait que les réacteurs sont des dispositifs assez coûteux en termes de capital, mais il présente l'inconvénient majeur de limiter le développement expérimental : les constantes ou variables choisies initialement définissent et/ou circonscrivent le résultat que ce soit en termes de design final et/ou de jeux de paramètres.
Ainsi bien que conscient de la nécessité de faire varier certains paramètres, l'Homme du métier tend à les limiter privilégiant des constantes et/ou des éléments fixes. La mise en oeuvre de dispositifs permettant une modulation d'un grand nombre d'éléments qu'ils soient liés aux caractéristiques physiques des réacteurs ou aux paramètres apparaît aujourd'hui limitée et contraire à la tendance des développements réalisés.
En matière de modulation des éléments physiques, l'Homme du métier a développé des portes-substrats mobiles et/ou interchangeables, car il est établi que la distance entre la surface de croissance et le plasma influe sur les caractéristiques du dépôt de diamant. Ainsi, la demande de brevet US2014220261, fait état d'un réacteur « bell jar » comprenant seulement deux éléments mobiles, et coulissants, dont le porte substrat afin de pouvoir moduler pendant les opérations les modes micro-ondes, les intensités de décharges, les densités de puissance et partant la forme et la taille du plasma. De même, la demande de brevet US2009239078 propose un dispositif dans un réacteur « bell jar » permettant d'inter-changer les porte-substrats pour adapter les conditions de dépôt. De même, Gicquel et al utilise un porte substrat mobile pour modifier la position du substrat dans le réacteur (A. Gicquel, M. Chennevier, M. Lefebvre, Chap 19, pp 739-796, Handbook of industrial diamond and diamond films, Marcel Dekker, 1998).
En début des phases de croissance et/ou en cours de croissance, les variables expérimentales telles que pression, puissance, débits de gaz, concentrations, ou compositions ou autres sont fréquemment ajustées les unes par rapport aux autres (réduction ou accroissement des débits, etc).

Pour autant, la modularité conçue comme un dispositif structurant dans le design d'un réacteur et comme un agencement favorisant l'interaction et la combinatoire des dispositifs physiques et des variables expérimentales semble être écartée par les Hommes du métier, privilégiant la recherche d'un réacteur « optimisé », simplifié pour une utilisation particulière, avec des pièces et éléments ajustables et modulables réduits autant que faire se peut.

Ainsi, dans la demande de brevet US2014220261 cité ci-dessus faisant état de pièces mobiles, les inventeurs ont choisi de proposer des « kits » de pièces aux diamètres ou caractéristiques différentes permettant de composer différents réacteurs à partir de différents éléments de base et non de moduler les éléments de base en cours de croissance.

De même, dans le brevet US8859058 dans la description de l'invention, les inventeurs font état de leur volonté de « simplifier le réacteur » en réduisant le nombre de composants amovibles ou mobiles. La demande de brevet GB 2486783 A concerne un réacteur plasma à micro-ondes pour la fabrication de diamant synthétique par dépôt chimique en phase vapeur, le réacteur plasma à micro-ondes comprenant : une chambre à plasma ; un support de substrat placé dans la chambre à plasma et comprenant une surface porteuse destinée à supporter un substrat sur lequel le diamant synthétique va être déposé en service ; une configuration de couplage de micro-ondes destinée à amener dans la chambre à plasma des micro-ondes provenant d'un générateur de micro-ondes ; et un système de circulation de gaz destiné à amener des gaz de traitement dans la chambre à plasma et à les en extraire. Le réacteur plasma à micro-ondes comprend en outre un anneau électriquement conducteur de stabilisation du plasma, placé autour du support de substrat dans la chambre à plasma.

Ainsi, il existe un besoin pour de nouveaux réacteurs capables de répondre aux problèmes engendrés par les réacteurs commerciaux disponibles actuellement.

## [Problème technique]

L'invention a pour but de remédier aux inconvénients de l'art antérieur. En particulier, l'invention a pour but de proposer un réacteur modulaire de dépôt par plasma assisté par microonde qui contrairement aux réacteurs de l'art antérieur est hautement modulaire.

De façon contre-intuitive et en décalage avec les tendances appliquées par l'Homme du métier ainsi qu'avec leurs propres travaux menés précédemment, les inventeurs ont au contraire constaté qu'un réacteur hautement modulaire mais conçu comme un ensemble homogène simplifiait à la fois la fabrication de couches de diamant pour une pluralité d'application et rendait plus aisés les développements et la maîtrise progressive des phases de croissance de diamants. Ces caractéristiques permettent en effet alternativement ou cumulativement de raccourcir les étapes, les risques d'erreurs, la maintenance, la durée et les coûts en cas d'ajustement ou modifications des configurations, tout en augmentant les possibilités de variation de variables et ainsi l'évolutivité tant des réacteurs que des procédés en ne réduisant pas la conception et les procédés de dépôts aux hypothèses et analyses préalables menées lors des phases de modélisation. Enfin, ils ont relevé que la combinatoire et la modulation concomitante, en cours de croissance, de plusieurs dispositifs physiques et variables expérimentales (comme la modulation concomitante de la distribution des débits de gaz et de leurs compositions, des conditions de pression / puissance, combinée à un mouvement du porte substrat, à la modification de la taille et de la forme de la cavité résonante, et à l'efficacité du pont thermique assurant le refroidissement du substrat) s'avéraient efficaces pour atteindre les objectifs poursuivis.

Cette modularité s'avère d'autant plus pertinente pour répondre au développement de l'industrie de synthèse du diamant, en particulier de celui des monocristaux de diamant de forte épaisseur et dans la configuration d'un accroissement de la taille des réacteurs et apparaît en ce sens particulièrement adaptée à des réacteurs fonctionnant à des fréquences inférieures à 1000 Mhz.

Le réacteur modulaire présente l'avantage de pouvoir ajuster la cavité sans avoir recourt à une nouvelle conception complète de la cavité voire du réacteur. L'invention permet en outre de perfectionner les moyens de calculs de cavité et de plasma mis en oeuvre.

La modularité de ce réacteur donne la possibilité, à partir d'un même réacteur d'aisément modifier la forme de la cavité, le volume de la cavité, la distribution des gaz, la position du substrat, son potentiel électrique par rapport à celui de la cavité et le refroidissement du substrat de façon à adapter le réacteur aux conditions de croissance des couches de diamant souhaitées (forme, microstructure, nombre, dimension). Cette modularité permet donc d'optimiser les réactions de synthèse aux différentes conditions de croissance et elle peut être particulièrement utile dans le cadre de la recherche des conditions de croissance optimales pour des applications particulières. En effet, toutes les croissances ne nécessitent pas les mêmes conditions et configurations en fonction par exemple des dimensions surfacique et en épaisseur de la couche de diamant à synthétiser, de leur forme, de la pureté attendue, des caractéristiques cristallines souhaitées, du dopage ou encore de la vitesse de croissance recherchée. Cette modularité des propriétés physiques présente le double avantage de permettre la création d'un seul équipement pour répondre aux besoins de plusieurs configurations, mais aussi au sein d'une même configuration initiale, de la faire varier pendant les phases de fonctionnement afin d'optimiser le résultat attendu.

En outre, ce réacteur modulaire à l'avantage de permettre un déplacement vertical du porte-substrat et donc du substrat dans le plasma et en limite de plasma, voire hors du plasma en cours du processus de dépôt. Ceci conduit à une maîtrise très grande des conditions locales de croissance à la surface du diamant en croissance. De plus, en matière économique, dans une industrie en développement, ce réacteur modulaire permet également de faire varier à moindre coût les différentes conditions de croissance sans avoir à investir dans de nouveaux prototypes et donc de gagner à la fois en vitesse et en réduction des coûts expérimentaux. Ce nouveau réacteur modulaire permet également d'assurer un refroidissement efficace de ses différents éléments, d'assurer un approvisionnement des gaz sectorisé et de permettre une observation continue du développement des croissances.

L'invention a en outre pour but de proposer un procédé de croissance tirant partie des propriétés modulaires de ce nouveau réacteur modulaire.

Des ensembles modulaires pouvant constituer le réacteur modulaire sont également proposés.

## [Brève description de l'invention]

A cet effet, l'invention porte sur un réacteur modulaire de dépôt assisté par plasma microonde pour la fabrication de diamant de synthèse, tel que défini par la revendication 1, ledit réacteur comprenant :

- un générateur de microonde configuré pour générer des microondes dont la fréquence est comprise entre 300 MHz et 3000 MHz, de préférence comprise entre 900 MHz et 1000 MHz ou entre 300 MHz et 500 MHz,
- une cavité résonante formée, au moins en partie, par les parois internes cylindriques d'une enceinte du réacteur,
- un système d'arrivée des gaz apte à apporter des gaz au sein de la cavité résonante,
- un module de sortie des gaz apte à retirer lesdits gaz de la cavité résonante,
- un module de couplage des ondes apte à transférer les microondes depuis le générateur de microonde jusqu'à la cavité résonante, de préférence initialement dans un mode TM011, de façon à permettre la formation d'un plasma, et
- un support de croissance présent dans la cavité résonante,

ledit réacteur modulaire comprenant au moins trois éléments de modulation, lesdits éléments de modulation étant sélectionnés parmi :

- une couronne apte à être positionnée entre une première partie d'enceinte et une deuxième partie d'enceinte de façon à modifier la forme et le volume de la cavité résonante, et un système de joints, permettant l'étanchéité du point de vue du vide et la continuité électrique des parois de l'enceinte, étant disposé entre la couronne et respectivement, la première partie d'enceinte et la deuxième partie de l'enceinte ;
- un module de porte substrat et un quart d'onde, ledit module de porte substrat étant mobile en translation verticale et en rotation, étant en contact avec le quart d'onde et comportant au moins un système de refroidissement fluide ;
- un plateau mobile en translation verticale de façon à modifier la forme et le volume de la cavité résonante et comportant des ouvertures traversantes permettant le passage des gaz ;
- un module de distribution des gaz, comportant :

    ◦ une plaque de distribution des gaz amovible comprenant une surface interne, une surface externe et une pluralité de buses de distribution des gaz formant des canaux entre les dites surfaces aptes à conduire un flux de gaz, et
    ◦ un dispositif de support relié à un système de refroidissement et apte à accueillir la plaque de distribution des gaz amovible ; et

- un module de contrôle du refroidissement du substrat, comportant un dispositif d'injection de gaz de résistance thermique amovible, ledit dispositif d'injection de gaz de résistance thermique amovible comprenant une ou plusieurs entrées de gaz de résistance thermique et une ou plusieurs sorties de gaz de résistance thermique.

Ce réacteur modulaire peut être optimisé pour une large gamme de conditions de croissance. En effet, un seul réacteur peut alors présenter des spécifications optimisées pour plusieurs applications ou même améliorer, pour une même application, les conditions en cours de croissance et cela sans avoir à être modifié dans sa structure. Ces éléments de modulation, combinés, permettent de modifier les caractéristiques du plasma et donc des conditions de croissance de façon à adapter le plasma à la croissance souhaitée.

**Selon d'autres caractéristiques optionnelles du réacteur** :

- Le réacteur modulaire de dépôt assisté par plasma microonde pour la fabrication de diamant de synthèse selon l'invention comprend au moins quatre éléments de modulation sélectionnés parmi les éléments de modulation listé ci-dessus. Cela permet d'augmenter encore la modularité du réacteur selon l'invention.

- Le réacteur modulaire de dépôt assisté par plasma microonde pour la fabrication de diamant de synthèse selon l'invention comprend un plateau mobile en translation verticale de façon à modifier la forme et le volume de la cavité résonante et comportant des ouvertures traversantes permettant le passage des gaz. Cela présente l'avantage pour l'utilisateur de pouvoir modifier rapidement les dimensions de la cavité résonante. Or, la modification des dimensions et de la forme de la cavité résonante va entraîner une modification de la forme du plasma et ainsi modifier les conditions locales de croissance du film de diamant. Le plateau selon l'invention présente l'avantage de pouvoir être déplacé avant une croissance mais également au cours d'une croissance. Cela donne la possibilité à l'utilisateur de modifier la forme, les caractéristiques et la position du plasma afin qu'elles soient adaptées à la position de la surface en croissance du substrat et à l'étape de la synthèse.

- Le plateau comporte au moins un canal de refroidissement relié à un système de refroidissement et apte à refroidir ledit plateau. Cela permet de limiter ou éviter sa déformation car il peut être soumis lors de son fonctionnement à de très fortes températures.

- Le réacteur modulaire de dépôt assisté par plasma microonde pour la fabrication de diamant de synthèse selon l'invention comprend un module de porte-substrat, mobile en translation verticale et en rotation, en contact avec un quart d'onde et éventuellement un isolant électrique et comportant au moins un système de refroidissement fluide. Ce porte-substrat permet de limiter la propagation des microondes en dehors de la cavité résonante tout en améliorant l'homogénéité de la croissance sur toute la surface de croissance et en donnant la possibilité de faire varier pendant une expérimentation la disposition du substrat par rapport au plasma. Il permet aussi éventuellement de rendre le support de croissance isolé électriquement du reste de l'enceinte. Cela est possible en isolant électriquement le module de porte substrat, de l'enceinte et/ou du plateau mobile. Ainsi, de façon préférée, le module de porte substrat est isolé électriquement de l'enceinte et/ou du plateau.

- Le porte substrat présente un rapport de volume compris entre 5 % et 30 % par rapport au volume de la cavité résonante et de préférence entre 7 à 13 %.

- Le réacteur modulaire de dépôt assisté par plasma microonde pour la fabrication de diamant de synthèse selon l'invention comprend au moins une couronne apte à être positionnée entre une première partie d'enceinte et une deuxième partie d'enceinte de façon à modifier la forme et le volume de la cavité résonante, et un système de joints, permettant l'étanchéité du point de vue du vide et la continuité électrique des parois de l'enceinte, étant disposé entre la couronne et respectivement, la première partie d'enceinte et la deuxième partie de l'enceinte. Cette couronne permet de faire varier la géométrie de la cavité résonante, par exemple en augmentant la distance entre la fenêtre diélectrique d'injection des ondes et le support de substrat. Cet élément modulaire permet ainsi d'optimiser les distributions radiales de la température du gaz et de la densité de H atomique dans le plasma et en conséquence à l'interface plasma / surface. Avantageusement, le réacteur modulaire comporte deux couronnes. Les couronnes peuvent présenter une hauteur comprise entre 1 cm et 20 cm.

- la ou les couronnes comportent un matériau diélectrique, un système d'injection de gaz ou sont constituées de métal avec un diamètre interne inférieur au diamètre interne de la cavité résonante.

- Le réacteur modulaire de dépôt assisté par plasma microonde pour la fabrication de diamant de synthèse selon l'invention comprend un module de distribution des gaz comportant :

    ○ une plaque de distribution des gaz amovible comprenant une surface interne, une surface externe et une pluralité de buses de distribution des gaz formant des canaux entre les dites surfaces aptes à conduire un flux de gaz, et
    ○ un dispositif de support relié à un système de refroidissement et apte à accueillir la plaque de distribution des gaz amovible.

Ce module de distribution des gaz présente l'avantage de fournir de bonnes caractéristiques d'écoulement de gaz. Ce module, dans ce contexte, est particulièrement utile dans le cadre de la modulation des conditions de croissance car étant donné qu'il est amovible, il peut être adapté en fonction de la position du ou des substrats, du nombre de substrats et de la durée anticipée de la réaction. En outre, les buses de distribution de gaz classiques présentent l'inconvénient de pouvoir s'encrasser. L'existence d'un tel module de distribution rend possible le remplacement de la plaque de distribution des gaz amovible, rapide et à moindre coût, sans avoir à remplacer tout un ensemble de pièces reliées à un tel module.

- Le dispositif de support comprend des canaux aptes à faire circuler un fluide dans ledit dispositif de support pour permettre d'établir un pont thermique rendant possible un refroidissement de la plaque de distribution des gaz amovible.

- La plaque de distribution des gaz amovible comporte au moins une partie extrême ne comprenant pas de buses de distribution et étant apte à être en contact avec le dispositif de support sur une surface de préférence supérieure à 10 % de la surface inférieure de la plaque de distribution des gaz amovible de façon à améliorer le transfert thermique. Cela permet d'améliorer le contrôle de la température du support de distribution et donc de sa géométrie.

- Le module de distribution de gaz comporte un organe de drain thermique positionné au-dessus de la plaque de distribution des gaz amovible et du dispositif de support, ledit drain thermique présentant par exemple une surface d'acquisition de la chaleur en contact avec la plaque de distribution des gaz amovible supérieure à 30 % de la surface supérieure de la plaque de distribution des gaz amovible et une surface de distribution de la chaleur en contact avec le dispositif de support supérieure à 20 % de la surface supérieure de la plaque de distribution des gaz amovible. Cela permet d'améliorer le contrôle de la température du système de distribution des gaz.

- Le réacteur modulaire de dépôt assisté par plasma microonde pour la fabrication de diamant de synthèse selon l'invention comprend un module de contrôle du refroidissement du substrat, comportant un dispositif d'injection de gaz de résistance thermique amovible, ledit dispositif d'injection de gaz de résistance thermique amovible comprend une ou plusieurs entrées de gaz de résistance thermique et une ou plusieurs sorties de gaz de résistance thermique. Ce dispositif permet d'introduire des mélanges de gaz différents, de faire varier les débits, et/ou de faire varier l'épaisseur du flux gazeux. Cela permet de pouvoir contrôler finement le refroidissement au niveau de la surface de croissance. Il peut être remplacé aisément entre deux croissances et s'adapter à la croissance escomptée et est ainsi particulièrement utile dans le cadre de la modulation des conditions de croissance. L'avantage de ce module est également qu'il est possible de remplacer cette pièce sans avoir à remplacer tout un ensemble de pièces reliées à un tel module de refroidissement. Ce module de contrôle du refroidissement du substrat permet également de moduler la température de la surface de croissance au cours de la croissance. Enfin, l'avantage de l'utilisation d'un dispositif d'injection de gaz de résistance thermique amovible est qu'il est possible de faire varier aisément plusieurs variables telles que les dimensions des sorties ou la densité des sorties.

- le module de contrôle du refroidissement du substrat comprend des moyens de positionnement et le support de croissance comporte sur sa surface inférieure des évidements aptes à accueillir les moyens de positionnement.

- le module de contrôle du refroidissement du substrat comprend des moyens de positionnement mobiles en translation verticale.

- Le moyen de couplage des ondes est situé dans la partie supérieure de la première partie de l'enceinte et au moins à 25 cm du bas de la deuxième partie d'enceinte, de préférence à au moins 35 cm de la base de la deuxième partie d'enceinte.

L'invention porte en outre sur un procédé de synthèse de diamant, tel que défini par la revendication 18, mettant en oeuvre un réacteur modulaire de dépôt assisté par plasma microonde pour la fabrication de diamant de synthèse, ledit procédé comprenant une étape de :

- placer le ou les substrats sur le support de croissance du réacteur modulaire selon l'invention,
- mettre en fonctionnement le réacteur modulaire, la dite mise en fonctionnement comprenant les étapes suivantes :

  ○ générer une pression comprise entre 0,2 hPa et 500 hPa au sein de la cavité résonante,
  ○ injecter des microondes en mode de transmission $TM_{011}$, et à une puissance comprise par exemple entre 1 kW et 100 kW,
  ○ injecter des gaz, par exemple à un débit total d'au moins 500 $cm^3$ par minute, et
  ○ mettre en fonctionnement des systèmes de refroidissement de l'enceinte, du système d'injection des gaz et du porte substrat, ainsi qu'un système de contrôle de refroidissement du substrat, pour contrôler la température de la ou des surfaces de croissance, et

- réaliser une croissance du film de diamant.

Dans le cas d'une croissance de film polycristallin, le procédé peut comprendre une étape de coalescence des cristaux avant l'étape d'épaississement du film de diamant.

D'autres avantages et caractéristiques de l'invention apparaîtront à la lecture de la description suivante donnée à titre d'exemple illustratif et non limitatif, en référence aux Figures annexées :

• la Figure 1, représente la vue schématique en coupe d'un exemple de réacteur selon l'état de la technique.

• la Figure 2, représente la vue schématique en coupe d'un réacteur modulaire selon l'invention comportant un plateau mobile, un module de porte substrat et une couronne.

• les Figures 3A, 3B et 3C, représentent les vues schématiques en coupe d'un quart d'onde mis en oeuvre avec un système d'isolation électrique entre le porte substrat et le plateau selon trois modes de réalisation dans un réacteur modulaire selon l'invention.

- la Figure 4, représente la vue schématique en coupe d'un réacteur modulaire selon l'invention comportant une couronne et un module de porte-substrat, lequel intègre un système de contrôle du refroidissement par gaz de résistance thermique.

- les Figures 5A et 5B, représentent la vue schématique selon une coupe longitudinale de deux modes de réalisation du module de contrôle du refroidissement du substrat.

- les Figures 6A et 6B, représentent une vue schématique du dessus de deux modules de contrôle du refroidissement du substrat.

- la Figure 7, représente la vue schématique en coupe d'un réacteur modulaire selon l'invention comportant une couronne d'épaisseur constante dans la partie haute de la cavité résonante intégrant un matériau diélectrique et une couronne présentant une protubérance dans la partie basse de la cavité résonante.

- la Figure 8, représente la vue schématique en coupe d'un réacteur modulaire selon l'invention comportant un module de porte substrat et un module de distribution des gaz.

- la Figure 9, représente la vue schématique en coupe d'un dispositif de support de la plaque de distribution des gaz amovible comprenant des canaux aptes à faire circuler un gaz ou un liquide dans ledit dispositif de support, pour refroidir la plaque de distribution.

- les Figures 10A et 10B, représentent la vue schématique du dessus d'un assemblage d'une plaque de distribution des gaz amovible et d'un dispositif de support, Figure 10A: la plaque de distribution des gaz amovible possédant une large bande de contact avec le dispositif de support sur toute sa circonférence et dépourvue de buses de distribution, ou Figure 10B : des zones ponctuelles dépourvues de buses.

- la Figure 11, représente la vue schématique du dessus d'un assemblage d'une plaque de distribution des gaz amovible et d'un dispositif de support, comprenant en outre un organe de drain thermique.

- la Figure 12, représente la vue schématique d'un procédé de synthèse de diamant dépôt assisté par plasma microonde selon l'invention. Les étapes encadrées par des pointillés sont facultatives.

**[Description de l'inventionl]**

Dans la suite de la description, on entend par « **sensiblement identique** » ou « **sensiblement égale** », une valeur variant de moins de 30 % par rapport à la valeur comparée, de préférence de moins de 20 %, de façon encore plus préférée de moins de 10 %. Lorsque sensiblement identique est utilisée pour comparer des formes alors la forme vectorisée, c'est-à-dire la forme sans prise en considération de ses dimensions, varie de moins de 30 % par rapport à la forme vectorisée comparée, de préférence de moins de 20 %, de façon encore plus préférée de moins de 10 %.

Le terme « **amovible** » au sens de l'invention correspond à la capacité à être détachée, enlevée ou démontée aisément sans avoir à détruire des moyens de fixation soit parce qu'il n'y a pas de moyen de fixation soit parce que les moyens de fixation sont aisément et rapidement démontables (e.g. encoche, vis, languette, ergot, clips). Par exemple, par amovible, il faut comprendre que l'objet n'est pas fixé par soudure ou par un autre moyen non prévu pour permettre de détacher l'objet.

Le terme « **croissance** » au sens de l'invention correspond à l'étape ou aux étapes de dépôt de carbone sous forme sp3 de diamant cristallin (polycristallin ou monocristallin) contribuant à la production d'une couche de diamant polycristallin, d'un monocristal de diamant ou encore de diamant nanocristallin ou ultra-nanocristallin.

Le terme « **diamant** » au sens de l'invention correspond à une ou plusieurs couches de diamant polycristallin ou monocristallin plus au moins épais, résultant du dépôt de carbone sous forme sp3 de diamant cristallin (polycristallin ou monocristallin). Notons que le « réacteur » de l'invention peut aussi être utilisé pour la croissance de diamant nanocristallin ou ultra-nanocristallin, moyennant une adaptation des conditions de croissance (température de la surface en croissance, composition du gaz, conditions de pression et de puissance, ...).

L'expression « **film de diamant** » ou « **couche de diamant** » au sens de l'invention correspond à une couche (ou un film) de diamant polycristallin, nanocristallin ou ultra-nanocristallin formée après nucléation sur une surface de matériau non diamant (métal, silicium, carbure de silicium, autres) mais également une surface de diamant monocristallin ou polycristallin. Il correspond également à l'obtention de diamant monocristallin par épaississement en hauteur et/ou en largeur d'un monocristal de diamant souche (ou substrat) provenant d'un monocristal de diamant naturel ou produit par procédé haute pression- haute température (HPHT) ou produit par CVD (chemical vapor déposition assisté par plasma ou par filament chaud, autre).

Le terme « **plasma** » au sens de l'invention correspond à la production, à partir d'une décharge électrique dans un gaz composé d'un mélange, d'un milieu globalement neutre électriquement mais contenant des ions et des électrons ainsi que des fragments des espèces gazeuses dissociées ainsi que des molécules stables.

Le terme « **substrat** » au sens de l'invention correspond aux éléments sur lesquels les couches ou films de diamant croissent. Il s'agit, pour les films polycristallins nanocristallin ou ultra-nanocristallin, de matériaux non diamant (métal, silicium, carbure de silicium, autres) ou diamant dans le cas de croissance multi-couches (multi-dopage ou multi-propriétés ou multi-couleurs, etc.) et pour les films monocristallins de monocristaux de diamant naturel ou produits par procédé haute pression- haute température (HPHT) ou encore produits par processus CVD (chemical vapor déposition assisté par plasma ou par filament chaud, autre).

L'expression « **gaz de résistance thermique**» au sens de l'invention correspond à un mélange gazeux composé de gaz purs ayant des conductivités thermiques très différentes permettant en changeant la composition de changer la conductivité thermique du mélange.

Le terme « **enceinte** » au sens de l'invention correspond à une chambre à vide en métal, de préférence en aluminium, destinée à recevoir un mélange de gaz qui, excité par une décharge électrique, forme un plasma, un ou des substrats à traiter par le plasma, et un support de croissance pouvant reposer sur un porte-substrat (chauffant ou refroidi, éventuellement polarisé). Un système de pompage assure la qualité de vide avant l'introduction des gaz. Les dimensions de l'enceinte peuvent être adaptées au générateur microonde utilisé, au coupleur et au gaz dans lequel s'effectue le dépôt d'énergie.

L'expression « **cavité résonante** » au sens de l'invention correspond à une sous-partie du volume formé par l'enceinte, cette sous-partie comportant notamment le lieu de formation du plasma et l'emplacement du ou des substrats. C'est dans la cavité résonante que la croissance est réalisée. La cavité résonante dépend d'un ensemble composé d'un générateur microonde, de l'applicateur et du système d'accord d'impédance, de la source de gaz où s'effectue le dépôt d'énergie microonde au sein de l'enceinte. La cavité résonante est constituée d'une partie de l'enceinte et des éléments tels que le support de croissance, le porte-substrat et le plateau mobile.

L'expression « **surface de croissance** » au sens de l'invention correspond à la surface située dans la cavité résonante et destinée à la croissance de diamant monocristallin ou de surfaces non diamant (croissance de diamant polycristallin).

L'expression « **support de croissance** » au sens de l'invention correspond à un élément, de préférence métallique, par exemple en molybdène, destiné à recevoir le ou les substrats. Ce support de croissance peut reposer sur un porte substrat par exemple via le dispositif d'injection des gaz de résistance thermique.

L'expression « **porte-substrat** » au sens de l'invention correspond à un dispositif de préférence cylindrique pouvant être refroidi par un fluide caloporteur tel que de l'huile silicone ou de l'eau, chargée ou non d'additifs, être associé à des éléments permettant l'ajustement du refroidissement du ou des substrats et/ou à des éléments permettant d'appliquer une tension ou de l'isoler électriquement de la cavité résonante.

Par « **modulaire** » il faut comprendre au sens de l'invention un système constitué d'un ensemble de modules, lesdits modules pouvant être ajoutés ou séparés du système de façon indépendante. Le module étant une sous-partie du système constituant une unité à la fois structurelle et fonctionnelle. Les modules peuvent être autonomes ou interconnectés. Dans ce cas, l'interconnexion éventuelle entre les modules et le système ou entre les modules est amovible au sens ci-dessus mentionné. Les possibilités du système peuvent croître ou se modifier par l'adjonction de ces modules.

Dans la suite de la description, les mêmes références sont utilisées pour désigner les mêmes éléments.

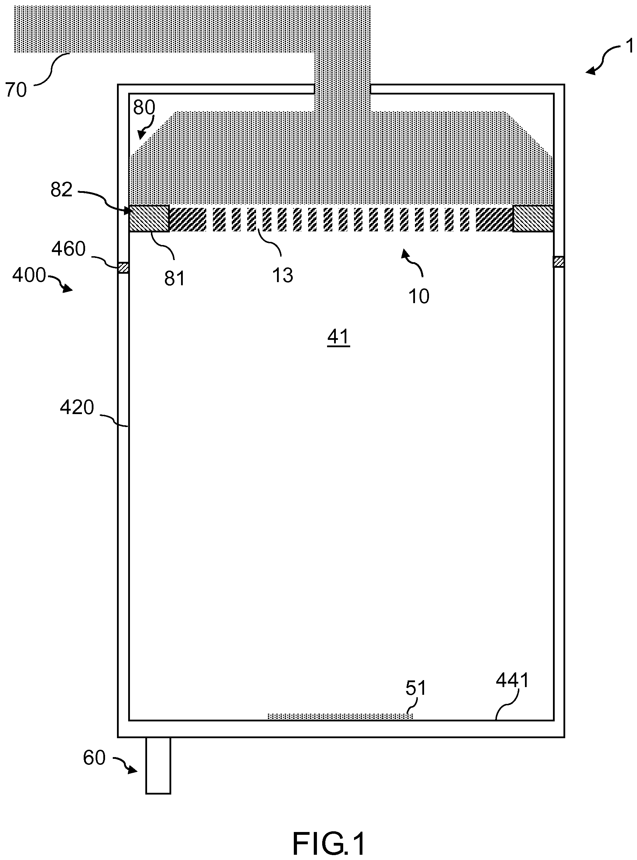

La **Figure 1** schématise une vue en coupe d'un réacteur de dépôt assisté par plasma microonde pour la croissance diamant tel qu'il est possible d'en trouver dans la littérature.

Un réacteur de dépôt assisté par plasma microonde pour la fabrication de diamant de synthèse, comprend généralement :

- un **générateur de microonde 70** configuré pour générer des microondes dont la fréquence est comprise entre 300 MHz et 3000 MHz,
- une **cavité résonante 41,** de préférence cylindrique et refroidie, formée au moins en partie, par les parois internes cylindriques 420 d'une enceinte 400 du réacteur modulaire 1,
- un **système d'arrivée des gaz 10** apte à apporter des gaz au sein de la cavité résonante 41,
- un **module de sortie des gaz 60** apte à retirer lesdits gaz de la cavité résonante 41,
- un **module de couplage des ondes 80** apte à transférer les microondes depuis le générateur de microonde jusqu'à la cavité résonante 41, de façon à permettre la formation d'un plasma, et
- un **support de croissance 51** présent dans la cavité résonante 41.

Les réacteurs de dépôt assisté par microonde permettent la résonance d'une onde stationnaire créée au sein de la cavité résonante 41. Cette résonance est possible grâce à une sélection précise des dimensions de la cavité résonante 41 et elle permet la création d'ondes stationnaires du champ électrique. Ces réacteurs sont configurés pour permettre un champ électrique maximal au sein de la cavité résonante 41, de préférence légèrement au-dessus du support de croissance 51. L'excitation par champ électromagnétique microonde permet, contrairement à l'excitation radiofréquence, de limiter très fortement l'action des ions sur les surfaces, en particulier sur les surfaces de croissance. En effet, la fréquence des électrons et des ions sont plus faibles que celle de l'onde excitatrice, et les ions et les électrons ne peuvent suivre la variation temporelle du champ électromagnétique. L'énergie moyenne des électrons est globalement plus faible que celle obtenue avec une excitation radiofréquence.

Ainsi, il est admis dans la littérature que les dimensions de la cavité et la composition du mélange de gaz et les conditions de fonctionnement d'un réacteur sont des critères essentiels à une résonance optimale et donc à une croissance du diamant optimale. Dans la ligne de cet enseignement, les réacteurs sont, si possible, conceptualisés puis leurs performances sont évaluées via des logiciels de modélisation permettant de prédire le comportement du plasma. Une fois les dimensions et la composition du gaz plasmagène déterminées, le réacteur est construit et ses dimensions n'évoluent plus. De plus, il a été montré que la pression, la puissance couplée au plasma et bien d'autres variables telles que la vitesse de l'écoulement, la position optimale du substrat en interaction avec les dimensions d'un réacteur sont aptes à influer la densité en hydrogène et du radical méthyl, l'épaisseur de la couche limite de diffusion, la température de la surface du substrat et en conséquence la croissance des couches de diamant.

Allant à l'encontre de cette ligne d'enseignement, les inventeurs ont mis au point un réacteur modulaire pour le dépôt assisté par plasma microonde. Ils ont développé un réacteur modulaire 1 de dépôt assisté par microonde comprenant plusieurs éléments de modulation pouvant être rapidement substitués et/ou aptes à modifier les caractéristiques du réacteur (e.g. dimensions de la cavité résonante 41) de façon à adapter le plasma à la croissance souhaitée. Ainsi, un seul réacteur peut alors présenter des spécifications modulables permettant d'optimiser le fonctionnement pour plusieurs applications ou même améliorer, pour une même application, les conditions en cours de croissance et cela sans avoir à être modifié dans sa structure. Par exemple, la modularité permettant de déplacer le plateau 900 et donc de modifier la hauteur de l'enceinte peut conduire à utiliser le fonctionnement multi-mode du système qui permet de modifier temporairement ou non les caractéristiques du plasma et donc des conditions de croissance. De même, l'introduction d'éléments perturbateurs dans la cavité résonante 41 permet de modifier temporairement ou non les caractéristiques du plasma et donc les conditions de croissance.

Le réacteur 1 de dépôt assisté par plasma microonde, dans un mode de réalisation ne faisant pas partie de l'invention, comprend au moins deux éléments de modulation, lesdits éléments de modulation étant sélectionnés parmi :

- une **couronne 450** apte à être positionnée entre une première partie d'enceinte 430 et une deuxième partie d'enceinte 440 de façon à modifier la forme et/ou le volume de la cavité résonante 41, et un système de joints 460, permettant l'étanchéité du point de vue du vide et la continuité électrique des parois de l'enceinte, étant disposé entre la couronne 450 et respectivement, la première partie d'enceinte 430 et la deuxième partie d'enceinte 440 ;

- un **module de porte substrat 500,** mobile en translation verticale et en rotation, en contact avec un quart d'onde 501 et comportant au moins un système de refroidissement fluide 520 ;
- un **plateau 900** mobile en translation verticale de façon à modifier la forme et le volume de la cavité résonante 41 et comportant des ouvertures traversantes 911 permettant le passage des gaz ;
- un **module de distribution des gaz 100,** comportant :

  ◦ une plaque de distribution des gaz amovible 110 comprenant une surface interne 111, une surface externe 112 et une pluralité de buses de distribution des gaz 113 formant des canaux entre les dites surfaces 111, 112 aptes à conduire un flux de gaz, et
  ◦ un dispositif de support 120 apte à accueillir la plaque de distribution des gaz amovible 110 ; et

- un **module de contrôle du refroidissement du substrat 300,** comportant un dispositif d'injection de gaz de résistance thermique amovible 330, ledit dispositif d'injection de gaz de résistance thermique amovible 330 comprend une ou plusieurs entrées de gaz de résistance thermique 333 et une ou plusieurs sorties de gaz de résistance thermique 331.

La présence de ces éléments de modulation au sein du réacteur, dans un mode de réalisation ne faisant pas partie de l'invention, permet à l'utilisateur d'aisément modifier certaines caractéristiques du réacteur sans avoir à le démonter entièrement ou à faire appel au fabricant.

De façon préférée, le réacteur 1 de dépôt assisté par plasma microonde selon l'invention comprend au moins trois éléments de modulation spécifiés ci-dessus. De façon plus préférée, il comprend au moins quatre éléments de modulation spécifiés ci-dessus et de façon encore plus préféré il comprend les cinq éléments de modulation spécifiés ci-dessus.

Alternativement, le réacteur 1 de dépôt assisté par plasma microonde, dans un mode de réalisation ne faisant pas partie de l'invention, comprend **un plateau 900** mobile en translation verticale de façon à modifier la forme et le volume de la cavité résonante 41 et comportant des ouvertures traversantes 911 permettant le passage des gaz, et au moins un, de préférence au moins deux, éléments de modulation sélectionnés parmi :

- un module de porte substrat 500, mobile en translation verticale et en rotation, en contact avec un quart d'onde 501 et comportant au moins un système de refroidissement fluide 520 ;
- une couronne 450 apte à être positionnée entre une première partie d'enceinte 430 et une deuxième partie d'enceinte 440 de façon à modifier la forme et/ou le volume de la cavité résonante 41, et un système de joints 460, permettant l'étanchéité du point de vue du vide et la continuité électrique des parois de l'enceinte, étant disposé entre la couronne 450 et respectivement, la première partie d'enceinte 430 et la deuxième partie d'enceinte 440 ;

- un module de distribution des gaz 100 comportant :

    ◦ une plaque de distribution des gaz amovible 110 comprenant une surface interne 111, une surface externe 112 et une pluralité de buses de distribution des gaz 113 formant des canaux entre les dites surfaces 111, 112 aptes à conduire un flux de gaz, et
    ◦ un dispositif de support 120 apte à accueillir la plaque de distribution des gaz amovible 110 ; et

- un module de contrôle du refroidissement du substrat 300, comportant un dispositif d'injection de gaz de résistance thermique amovible 330, ledit dispositif d'injection de gaz de résistance thermique amovible 330 comprend une ou plusieurs entrées de gaz de résistance thermique 333 et une ou plusieurs sorties de gaz de résistance thermique 331.

De façon préférée, le réacteur 1 de dépôt assisté par plasma microonde, dans un mode de réalisation ne faisant pas partie de l'invention, comprend **un plateau 900** mobile en translation verticale de façon à modifier la forme et le volume de la cavité résonante 41 et comportant des ouvertures traversantes 911 permettant le passage des gaz, et un **module de porte substrat 500,** mobile en translation verticale et en rotation, en contact avec un quart d'onde 501 et comportant au moins un système de refroidissement fluide 520. Ces deux éléments de modulation sont, de façon préférée, mobiles par exemple en translation verticale de façon indépendante. C'est-à-dire que le plateau 900 peut être déplacé sans que cela n'ait d'influence sur la position du module de porte-substrat 500, et inversement.

De façon plus préférée, le réacteur 1 de dépôt assisté par plasma microonde selon l'invention comprend un **plateau 900 mobile** en translation verticale de façon à modifier la forme et le volume de la cavité résonante 41 et comportant des ouvertures traversantes 911 permettant le passage des gaz, un **module de porte substrat 500,** mobile en translation verticale et en rotation, en contact avec un quart d'onde 501 et comportant au moins un système de refroidissement fluide 520, et un **module de contrôle du refroidissement du substrat 300,** comportant un dispositif d'injection de gaz de résistance thermique amovible 330, ledit dispositif d'injection de gaz de résistance thermique amovible 330 comprend une ou plusieurs entrées de gaz de résistance thermique 333 et une ou plusieurs sorties de gaz de résistance thermique 331.

Alternativement, le réacteur 1 de dépôt assisté par plasma microonde, dans un mode de réalisation ne faisant pas partie de l'invention, comprend un **module**

**de porte substrat 500,** mobile en translation verticale et en rotation, en contact avec un quart d'onde 501 et comportant au moins un système de refroidissement fluide 520, et au moins un, de préférence au moins deux, éléments de modulation sélectionnés parmi :

- un plateau 900 mobile en translation verticale de façon à modifier la forme et le volume de la cavité résonante 41 et comportant des ouvertures traversantes 911 permettant le passage des gaz ;
- une couronne 450 apte à être positionnée entre une première partie d'enceinte 430 et une deuxième partie d'enceinte 440 de façon à modifier la forme et/ou le volume de la cavité résonante 41, et un système de joints 460, permettant l'étanchéité tant du point de vue du vide que du point de vue électrique de l'enceinte, étant disposé entre la couronne 450 et respectivement, la première partie d'enceinte 430 et la deuxième partie d'enceinte 440 ;
- un module de distribution des gaz 100 comportant :

    ◦ une plaque de distribution des gaz amovible 110 comprenant une surface interne 111, une surface externe 112 et une pluralité de buses de distribution des gaz 113 formant des canaux entre les dites surfaces 111, 112 aptes à conduire un flux de gaz, et
    ◦ un dispositif de support 120 apte à accueillir la plaque de distribution des gaz amovible 110 ; et

- un module de contrôle du refroidissement du substrat 300, comportant un dispositif d'injection de gaz de résistance thermique amovible 330, ledit dispositif d'injection de gaz de résistance thermique amovible 330 comprend une ou plusieurs entrées de gaz de résistance thermique 333 et une ou plusieurs sorties de gaz de résistance thermique 331.

De façon préférée, le réacteur 1 de dépôt assisté par plasma microonde, dans un mode de réalisation ne faisant pas partie de l'invention, comprend un **module de porte substrat 500,** mobile en translation verticale et en rotation, en contact avec un quart d'onde 501 et comportant au moins un système de refroidissement fluide 520, et un **module de contrôle du refroidissement du substrat 300,** comportant un dispositif d'injection de gaz de résistance thermique amovible 330, ledit dispositif d'injection de gaz de résistance thermique amovible 330 comprend une ou plusieurs entrées de gaz de résistance thermique 333 et une ou plusieurs sorties de gaz de résistance thermique 331.

Alternativement, le réacteur 1 de dépôt assisté par plasma microonde, dans un mode de réalisation ne faisant pas partie de l'invention, comprend **une couronne 450** apte à être positionnée entre une première partie d'enceinte 430 et une deuxième partie d'enceinte 440 de façon à modifier la forme et/ou le volume de la cavité résonante 41, et un système de joints 460, permettant l'étanchéité du point de vue du vide et la continuité électrique des parois de l'enceinte, étant disposé entre la couronne 450 et respectivement, la première partie d'enceinte 430 et la deuxième partie d'enceinte 440 ; et au moins un, de préférence au moins deux, élément modulaire sélectionné parmi :

- un plateau 900 mobile en translation verticale de façon à modifier la forme et le volume de la cavité résonante 41 et comportant des ouvertures traversantes 911 permettant le passage des gaz ;
- un module de porte substrat 500, mobile en translation verticale et en rotation, en contact avec un quart d'onde 501 et comportant au moins un système de refroidissement fluide 520 ;
- un module de distribution des gaz 100 comportant :

   ◦ une plaque de distribution des gaz amovible 110 comprenant une surface interne 111, une surface externe 112 et une pluralité de buses de distribution des gaz 113 formant des canaux entre les dites surfaces 111, 112 aptes à conduire un flux de gaz, et
   ◦ un dispositif de support 120 apte à accueillir la plaque de distribution des gaz amovible 110 ; et

- un module de contrôle du refroidissement du substrat 300, comportant un dispositif d'injection de gaz de résistance thermique amovible 330, ledit dispositif d'injection de gaz de résistance thermique amovible 330 comprend une ou plusieurs entrées de gaz de résistance thermique 333 et une ou plusieurs sorties de gaz de résistance thermique 331.

Alternativement, le réacteur 1 de dépôt assisté par plasma microonde, dans un mode de réalisation ne faisant pas partie de l'invention, comprend un **module de distribution des gaz 100**, comportant une plaque de distribution des gaz amovible 110 comprenant une surface interne 111, une surface externe 112 et une pluralité de buses de distribution des gaz 113 formant des canaux entre les dites surfaces 111, 112 aptes à conduire un flux de gaz, et un dispositif de support 120 apte à accueillir la plaque de distribution des gaz amovible 110, et au moins un, de préférence au moins deux, éléments de modulation sélectionnés parmi :

- un plateau 900 mobile en translation verticale de façon à modifier la forme et le volume de la cavité résonante 41 et comportant des ouvertures traversantes 911 permettant le passage des gaz ;
- un module de porte substrat 500, mobile en translation verticale et en rotation, en contact avec un quart d'onde 501 et comportant au moins un système de refroidissement fluide 520 ;
- une couronne 450 apte à être positionnée entre une première partie d'enceinte 430 et une deuxième partie d'enceinte 440 de façon à modifier la forme et/ou le volume de la cavité résonante 41, et un système de joints 460, permettant l'étanchéité du point de vue du vide et la continuité électrique des parois de l'enceinte, étant disposé entre la couronne 450 et respectivement, la première partie d'enceinte 430 et la deuxième partie d'enceinte 440 ;
- un module de contrôle du refroidissement du substrat 300, comportant un dispositif d'injection de gaz de résistance thermique amovible 330, ledit dispositif d'injection de gaz de résistance thermique amovible 330 comprend une ou plusieurs entrées de gaz de résistance thermique 333 et une ou plusieurs sorties de gaz de résistance thermique 331.

Alternativement, le réacteur 1 de dépôt assisté par plasma microonde, dans un mode de réalisation ne faisant pas partie de l'invention, comprend un **module de contrôle du refroidissement du substrat 300,** comportant un dispositif d'injection de gaz de résistance thermique amovible 330, ledit dispositif d'injection de gaz de résistance thermique amovible 330 comprend une ou plusieurs entrées de gaz de résistance thermique 333 et une ou plusieurs sorties de gaz de résistance thermique 331, et au moins un, de préférence au moins deux, éléments de modulation sélectionnés parmi :

- un plateau 900 mobile en translation verticale de façon à modifier la forme et le volume de la cavité résonante 41 et comportant des ouvertures traversantes 911 permettant le passage des gaz ;
- un module de porte substrat 500, mobile en translation verticale et en rotation, en contact avec un quart d'onde 501 et comportant au moins un système de refroidissement fluide 520 ;
- une couronne 450 apte à être positionnée entre une première partie d'enceinte 430 et une deuxième partie d'enceinte 440 de façon à modifier la forme et/ou le volume de la cavité résonante 41, et un système de joints 460, permettant l'étanchéité du point de vue du vide et la continuité électrique des parois de l'enceinte, étant disposé entre la couronne 450 et respectivement, la première partie d'enceinte 430 et la deuxième partie d'enceinte 440 ;
- un module de distribution des gaz 100 comportant :

   ◦ une plaque de distribution des gaz amovible 110 comprenant une surface interne 111, une surface externe 112 et une pluralité de buses de distribution des gaz 113 formant des canaux entre les dites surfaces 111, 112 aptes à conduire un flux de gaz, et
   ◦ un dispositif de support 120 apte à accueillir la plaque de distribution des gaz amovible 110.

Outre ces éléments de modulation propres à l'invention et permettant de disposer, rapidement et à moindre coût, d'un réacteur pouvant être optimisé pour une large gamme de conditions de croissance, le réacteur selon l'invention comporte les composants essentiels à tout réacteur de dépôt assisté par plasma microonde.

Le **générateur de microonde 70** est configuré pour générer des microondes dont la fréquence est comprise entre 300 MHz et 3000 MHz. Ces microondes sont essentielles à la création des ondes stationnaires de champ électrique au sein de la cavité. De préférence, le générateur de microonde 70 est configuré pour générer des microondes dont la fréquence est comprise entre 400 MHz et 2700 MHz. De façon encore plus préférée, le générateur est configuré pour générer des microondes dont la fréquence est comprise entre 900 MHz et 1000 MHz de façon à accroître le bénéfice de la modularité apportée par le réacteur selon l'invention. En effet, le réacteur 1 selon l'invention est particulièrement avantageux pour les réacteurs de grandes dimensions tels que ceux opérant à des fréquences comprises entre 900 MHz et 1000 MHz ou entre 300 MHz et 500 MHz. Un réacteur modulaire 1 selon l'invention couplé à de tels générateurs permet de proposer un jeu d'option de fabrication de produits jusque-là inédits et ainsi répondre aux besoins d'industries plus variées.

Par exemple, le générateur peut générer des microondes dont la fréquence est sensiblement égale à 2450 MHz, 915 MHz ou 433 MHz.

Il existe un grand nombre de générateurs pouvant être utilisés dans le cadre du réacteur 1 selon l'invention. Le générateur utilisé peut par exemple être un générateur microonde apte à délivrer une puissance allant jusqu'à 6 kW et ceci à une fréquence sensiblement égale à 2450 MHz. Un autre générateur microonde apte à délivrer une puissance allant jusqu'à 30 kW, 50 kW ou même 100 kW et ceci à une fréquence sensiblement égale à 915 MHz peut également être utilisé. Egalement, un autre générateur microonde fonctionnant à une fréquence sensiblement égale à 433 MHz peut être utilisé.

L'alimentation en microonde de la cavité, ou couplage, est réalisé par un **module de couplage des ondes 80** apte à transférer les microondes depuis le générateur de microonde 70 jusqu'à la cavité résonante 41 de façon à permettre la formation d'un plasma. Le module de couplage permet d'injecter, dans la cavité résonante 41, l'onde générée par le générateur de microonde 70 et pour cela il comporte un guide d'onde, une transition coaxiale et un coupleur microonde pour convoyer et guider les ondes électromagnétiques depuis le générateur d'ondes 70 jusqu'à la cavité résonante 41. Les modes de propagations proposés par le guide d'onde peuvent être de deux types :

- le mode transverse magnétique ($TM_{0mn}$), l'axe du champ magnétique est perpendiculaire à l'axe de la cavité, le champ magnétique incident est perpendiculaire au plan d'incidence (alors le champ électrique est dans le plan d'incidence), et
- le mode transverse électrique ($TE_{0mn}$), l'axe du champ électrique est perpendiculaire à l'axe de la cavité, et le champ électrique incident est perpendiculaire au plan d'incidence (alors le champ magnétique est dans le plan d'incidence).

Les indices m et n indiquent le nombre de maxima des variations sinusoïdales du champ électrique respectivement radialement et selon l'axe de la cavité résonante 41 pour le mode transverse TMOmn. Pour une description des différents modes utilisables, l'homme du métier peut se référer à Silva et al. (Silva et al. 2009 ; Microwave engineering of plasma -assisted CVD reactors for diamond déposition. Journal of Physics: Condensed Matter ou à J. Asmussen, Chap 6 of High density plasma sources, edit O A Popov, Noyés publications, 1995). Les modes TMOmn permettent d'obtenir des plasmas axisymétriques. Le couplage est réalisé de préférence au moyen d'une fenêtre diélectrique et de préférence, le système de guide d'onde est refroidi, par exemple par un moyen de refroidissement comportant un liquide. Les couplages possibles et optimaux pour les réacteurs de dépôt assisté par plasma microonde sont décrits dans la littérature (Kudela terebessy et al Applied Physics Letter vol 80, N°7, 2002 ; D G Goodwin J. Appl. Phys. 74-11, 1993 ; H. Yamada, et al., DRM, 17, 2008; X. Li, et al. Physics procedia 22, 2011 ; J. Weng et al., DRM 30, 2012 ; Yutaka Ando et al., DRM, 11, 2002 ; Takeshi Tachibanaa et al. Diamond and Related Materials 10 2001).

De préférence, le mode de couplage dans le réacteur 1 (i.e. dans la cavité résonante 41) selon l'invention est configuré de façon à être monomode au moment de l'allumage du plasma, de façon plus préférée en mode transmission magnétique. De façon encore plus préférée, le système est configuré initialement pour fonctionner en mode $TM_{011}$ c'est-à-dire présentant un seul maxima de champ électrique sur l'axe du réacteur et sur la composante radiale. L'avantage de l'utilisation du mode $TM_{011}$ dans le cadre de l'invention est de pouvoir facilement créer un plasma qui présente une forme adaptée pour le dépôt de diamant. En effet, afin de permettre un dépôt d'énergie important à l'interface plasma / surface, le plasma ne peut avoir une épaisseur très supérieure à l'épaisseur de pénétration de l'onde.

De préférence, le module de couplage des ondes 80 est positionné au-dessus de la cavité résonante 41 et comporte une fenêtre diélectrique d'injection des ondes 82 dont la face 81 est positionnée parallèlement au support de croissance 51, et déportée vers l'extérieur afin de limiter l'effet de chauffage de la fenêtre dû à la convection naturelle se déroulant dans le cœur du plasma qui conduirait à sa gravure / détérioration et à une possible pollution des couches de diamant.

**L'enceinte 400** peut présenter différentes formes et dimensions. De préférence l'enceinte 400 est de forme cylindrique mais elle peut prendre d'autres formes. Lorsque le réacteur 1 selon l'invention comporte le plateau 900 comme élément modulaire qui permet de changer la hauteur de la cavité résonante 41. La hauteur de l'enceinte, telle que mesurée depuis la base 441 de l'enceinte 440 jusqu'à la surface interne 81 du guide d'onde, peut être comprise par exemple entre 150 mm et 600 mm, de préférence 200 mm à 500 mm et de façon plus préférée entre 350 mm et 450 mm. Ces toutes dernières dimensions sont particulièrement préférées pour un fonctionnement à une fréquence micro-onde dans la plage de 900 MHz à 1000 MHz. De même dans la suite de la description de la présente invention, sauf si indiqué autrement, les dimensions seront particulièrement adaptées à un réacteur modulaire 1 opérant à des fréquences comprises entre 900 MHz et 1000 MHz. Sauf si indiqué autrement, les dimensions préférées ou les conditions de croissance pour un réacteur modulaire 1 opérant à des fréquences comprises entre 300 MHz et 500 MHz pourront être obtenues en multipliant les dimensions adaptées à un réacteur modulaire 1 opérant à des fréquences comprises entre 900 MHz et 1000 MHz, par un facteur compris entre 3,4 et 1,8. Sauf si indiqué autrement, les dimensions préférées ou les conditions de croissance pour un réacteur modulaire 1 opérant à des fréquences comprises entre 2300 MHz et 2600 MHz pourront être obtenues en divisant les dimensions adaptées à un réacteur modulaire 1 opérant à des fréquences comprises entre 900 MHz et 1000 MHz, par un facteur compris entre 2,3 et 2,9.

L'enceinte 400 selon l'invention est généralement constituée de métal, de préférence constituée d'aluminium ou d'un alliage d'aluminium. L'alliage d'aluminium comprend de préférence au moins 80%, de façon plus préférée au moins 90%, et de façon encore plus préférée au moins 98% en poids d'aluminium.

La **cavité résonante 41** est formée, au moins en partie, par les parois internes cylindriques 420 de l'enceinte 400 du réacteur 1. La cavité résonante 41 est formée pour sa partie inférieure par la base 441 de l'enceinte 400 ou par la surface 910 du plateau 900. Selon un mode de réalisation, elle comprend également le module de porte-substrat 500, destiné à recevoir le support de croissance et le ou les substrats, si sa surface est en continuité électrique avec le plateau 900 et les parois de l'enceinte et tout élément métallique pouvant être éventuellement confiné dans la cavité résonante 41. La cavité résonante 41 est de préférence cylindrique. La cavité résonante 41 possède un axe de symétrie partant du plan de la base 441 de l'enceinte jusqu'au plan de la surface 81 de la fenêtre diélectrique d'injection des ondes 82 et est de préférence adaptée à un mode de résonance de micro-ondes de type TM. La base 441 peut présenter un diamètre différent du diamètre de la cavité résonante 41.

Le réacteur 1 comme présenté sur la figure 1 comprend également un **support de croissance 51** situé dans la cavité résonante 41. Ce support de croissance 51 peut, par exemple, former une grande surface plane, sur laquelle le ou les substrats sont destinés à être positionnés. Ce support de croissance 51 peut comprendre des saillies, des cercles, des trous ou des rainures, permettant d'aligner et de maintenir le ou les substrat(s). En variante, le support de croissance 51 comporte une surface de support plane sur laquelle le ou les substrats sont disposés.

Le réacteur de dépôt assisté par plasma microonde comprend **un système d'arrivée des gaz 10** apte à apporter des gaz au sein de la cavité résonante 41. Ce système d'arrivée des gaz 10 permet de mettre en oeuvre un procédé où les gaz de traitement sont injectés vers la surface de croissance à un débit total de gaz d'au moins 100 cm$^3$ par minute. Les gaz apportés au sein de la cavité résonante 41 comprennent au moins une source de carbone et une source d'hydrogène moléculaire. La source de carbone est de préférence du méthane. Pour un réacteur modulaire 1 opérant à des fréquences comprises entre 900 MHz et 1000 MHz, le débit de gaz est de préférence d'au moins 750 cm$^3$ par minute, de façon plus préférée d'au moins 1000 cm$^3$ par minute. Au sein de la cavité résonante 41, ces gaz sont activés par les microondes pour former un plasma dans les régions de champ électrique élevé. Des radicaux contenant du carbone réactif peuvent ensuite diffuser à partir du plasma pour se déposer sur le ou les substrats et ainsi permettre la croissance du diamant.

Le système d'arrivée des gaz 10 peut permettre un apport en azote dans la cavité résonante 41, par exemple d'au moins 0,3 ppm d'azote. L'utilisation d'azote au sein de la cavité résonante 41 est connue pour pouvoir augmenter la vitesse de croissance des couches de diamant et permettre une plus grande stabilité cristalline.

Le système d'arrivée des gaz 10 peut également permettre l'injection dans la cavité résonante 41 d'un ou plusieurs gaz dits dopants comprenant des éléments tels que le bore, le soufre, le phosphore, le silicium, le lithium et le béryllium, autre. Ainsi, le système d'arrivée des gaz 10 permet de mettre en oeuvre un procédé où les gaz comprennent au moins un dopant à une concentration égale ou supérieure à 0,01 ppm. L'utilisation de tels gaz dits dopants permet de modifier les propriétés du diamant synthétisé. Cela peut par exemple modifier ses propriétés optiques et/ou électroniques.

Le système d'arrivée des gaz 10 peut également permettre l'injection d'autres gaz pouvant être avantageux pour la réalisation de certaines croissances tels que l'argon, l'oxygène ou autres gaz habituellement utilisés.

Le **module de sortie des gaz 60** permet d'évacuer les gaz présents dans la cavité résonante 41. Il comprend une ou plusieurs sorties de gaz 61, situées de préférence dans la partie inférieure du réacteur de dépôt.

Une ou plusieurs sorties de gaz 61 peuvent être situées autour du et sous le support de croissance 51, selon un arrangement axisymétrique.

**L'enceinte 400** du réacteur modulaire de dépôt assisté par plasma microonde selon l'invention peut consister en au moins deux parties qui lorsqu'elles sont rassemblées, forment en partie la cavité résonante 41.

Compte tenu de la température du gaz atteinte dans le cœur du plasma (e.g. plus de 2500K et jusqu'à 5000K), un refroidissement extrêmement efficace des parois du réacteur est nécessaire.

La température de gaz du plasma se répercute sur les parois qui sont soumises à un flux de chaleur important. Pour pallier cela un système de refroidissement des parois est généralement mis en oeuvre.

Les inventeurs proposent de partager l'enceinte en au moins deux parties chacune accueillant une partie des éléments nécessaires au fonctionnement du réacteur de dépôt. Par exemple, la première partie d'enceinte 430 englobe le système d'arrivée des gaz 10 et le module de couplage des ondes 80, tandis que la deuxième partie d'enceinte 440 englobe le module de sortie des gaz 60, le support de croissance 51, le plateau 900 et le cas échéant le porte-substrat.

De façon avantageuse, la deuxième partie de l'enceinte 440 est de préférence amovible sans avoir à séparer le système d'arrivée des gaz 10 ou le module de couplage des ondes 80 de la première partie d'enceinte 430.

En outre, le réacteur 1 comporte de préférence un système de refroidissement 490 configuré pour refroidir indépendamment la première partie d'enceinte 430 et la deuxième partie de l'enceinte 440.

Le système de refroidissement 490 peut également être configuré pour induire une diminution de température plus forte sur l'une des deux parties d'enceinte 430, 440.

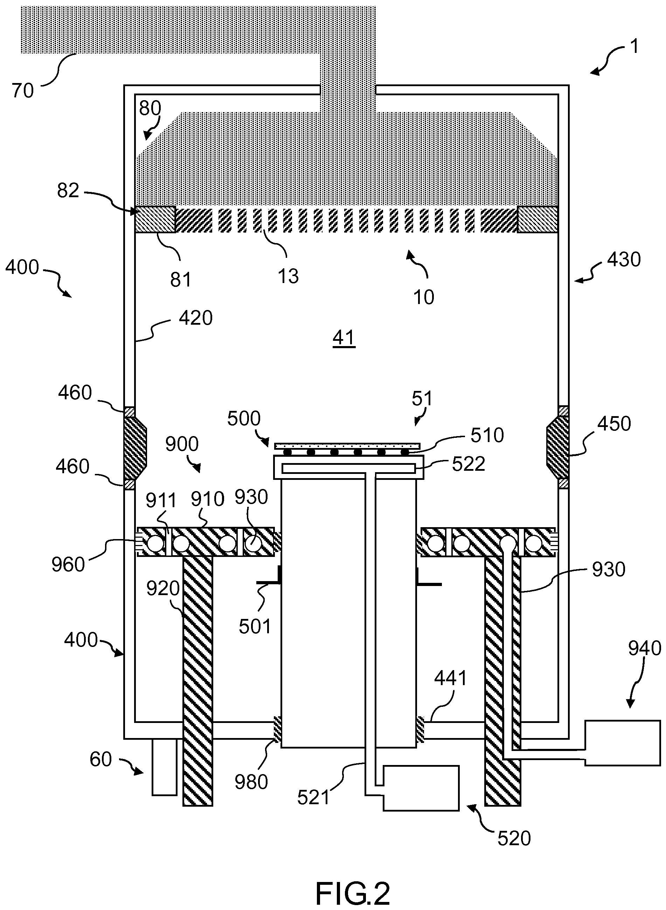

Comme cela a été évoqué, un des éléments de modulation proposés par les inventeurs est un **plateau 900** apte à se déplacer en translation verticale de façon à la forme et le volume de la cavité résonante 41. En outre, lors du fonctionnement du réacteur, le plateau est apte à modifier la forme et le volume du plasma. Ce plateau 900 est présenté sur la **figure 2.**

Ce plateau 900 apte à se déplacer en translation verticale présente l'avantage pour l'utilisateur de pouvoir modifier rapidement les dimensions de la cavité résonante 41. Or, la modification des dimensions et de la forme de la cavité résonante 41 en fonction par exemple des conditions de composition de gaz, pression, puissance va entraîner une modification des propriétés diélectriques du plasma et donc de sa forme et ainsi modifier les conditions locales de croissance du film de diamant. Le plateau 900 selon l'invention présente l'avantage de pouvoir être déplacé avant une croissance mais également au cours d'une croissance. Cela donne la possibilité à l'utilisateur de modifier la forme, les caractéristiques et la position du plasma afin qu'elles soient adaptées pour la position de la surface en croissance du substrat et l'étape de synthèse.

Le plateau 900 peut par exemple présenter une épaisseur comprise entre 1 et 10 cm. L'épaisseur ne doit pas être trop importante de façon à réduire la quantité de matériaux utilisée pour la fabrication mais elle doit également être suffisante pour empêcher la déformation du plateau 900 que pourrait induire le plasma en cours d'expérience et permettre le placement du ou des canaux de refroidissement le cas échéant. De façon préférée, le plateau 900 présente une épaisseur comprise entre 2 cm et 8 cm.

Le plateau 900 peut être constitué de différents matériaux métalliques. De préférence, il comprend du molybdène, du cuivre, de l'aluminium et/ou un alliage d'aluminium.

En outre, comme cela est présenté sur la figure 2, le plateau 900 selon l'invention comporte des ouvertures traversantes 911 permettant le passage des gaz. Cela est particulièrement avantageux lorsque une ou plusieurs sorties de gaz 61 sont situées dans la partie basse de l'enceinte. De préférence, le plateau 900 comporte entre 5 et 15 ouvertures traversantes 911. Ces ouvertures traversantes sont de préférence de forme cylindrique avec un diamètre compris entre 1 et 5 cm. Ces ouvertures traversantes sont avantageusement verticales et par exemple perpendiculaires à la face supérieure 910 du plateau 900.

De préférence, les ouvertures traversantes 911 sont positionnées aux extrémités du plateau, c'est-à-dire à proximité de la bordure extérieure du plateau. En outre, la somme de l'aire de ces ouvertures traversantes 911 sur la surface supérieure du plateau 900 est de préférence comprise entre 4 à 100 cm².

Le plateau 900 est apte à se déplacer en translation par exemple grâce à des vérins 920 auxquels il est relié. Ces vérins sont de préférence situés à l'extérieur du volume formé par l'enceinte 400. Ils peuvent être remplacés par tout mécanisme permettant un déplacement lent et précis du plateau 900. Le plateau 900 peut également être associé à des soufflets ou à un système de guidage de façon à améliorer son déplacement en translation verticale.

Le plateau 900 peut être soumis lors de son fonctionnement à de très fortes températures. Ainsi, afin d'une part de limiter ou éviter sa déformation et d'autre part de réduire la perturbation du plasma, le plateau 900 peut comporter au moins un canal de refroidissement 930 relié à un système de refroidissement 940 et apte à refroidir ledit plateau 900.

Avantageusement, le plateau 900 est amovible. Il peut être aisément retiré et remplacé par un autre plateau 900 pouvant être de dimensions et/ou de forme différentes et apte à se lier au système de mise en translation verticale et/ou au système de refroidissement 940.

La surface du plateau 900 est de préférence plane mais le plateau 900 peut présenter un évidement en son centre. Un tel évidement est apte recevoir un porte substrat de façon à ce que ce dernier soit positionné de façon précise au sein de la cavité.

Le plateau 900 peut comporter une sous-partie ayant la forme d'un disque plein mais de façon préférée, le plateau 900 peut présenter une sous-partie ayant la forme d'un disque plein dont le centre a été supprimé comme cela est présenté sur la figure 2.

Le plateau 900 peut présenter une face supérieure 910 dont la surface est supérieure à 50 %, à de préférence supérieure à 60%, de la surface de la section transversale de l'enceinte 400 au niveau du support de croissance 51. Ainsi, de façon préférée, le plateau 900 présente une face supérieure 910 dont la surface est comprise entre 60 % et 95 % de la surface de la section transversale de l'enceinte 400 au niveau du support de croissance 51, de façon plus préférée la surface est comprise entre 70 % et 90 % de la surface de la section transversale de l'enceinte 400 au niveau du support de croissance 51, de façon encore plus préférée la surface est comprise entre 80 % et 90 % de la surface de la section transversale de l'enceinte 400 au niveau du support de croissance 51. Ces dimensions permettent de moduler plus efficacement le plasma qu'avec un plateau de surface réduite. Ces chiffres ne prennent pas en compte les ouvertures traversantes 911.

De façon avantageuse, le plateau 900 présente une surface supérieure 910 ayant une aire plus grande que celle du support de croissance 51. De façon préférée, le plateau 900 présente une surface supérieure 910 ayant une aire représentant plus de 1500 % de l'aire du support de croissance 51 et de façon encore plus préférée, le plateau 900 présente une surface supérieure 910 ayant une aire représentant plus de 550 % de celle du support de croissance 51 pour un réacteur de type 900 - 1000 MHz.

Avantageusement, le plateau 900 peut comporter un système d'éléments 960 aptes à maintenir un contact électrique avec les parois internes 420 de l'enceinte 400 et donc maintenir une continuité électrique avec l'enceinte, ainsi qu'avec le module de porte-substrat 500 dans le cas où le module de porte-substrat 500 fait partie intégrante de la cavité résonante 41. Ces éléments 960 peuvent par exemple comporter ou être constitués d'un alliage de Cuivre-Béryllium.

Un autre des éléments de modulation proposés par les inventeurs est un **module de porte substrat 500,** en contact avec un quart d'onde 501 et comportant au moins un système de refroidissement fluide 520, configuré pour permettre le déplacement en translation verticale et en rotation du support de croissance 51. Ce module de porte substrat 500 est présenté sur la **figure 2.**

Avantageusement le module de porte substrat 500 est amovible et présente l'avantage de pouvoir être retiré aisément du réacteur afin par exemple d'être remplacé par un autre module de porte substrat 500 amovible.

Le module de porte substrat 500 selon l'invention présente l'avantage d'être apte à se déplacer en translation verticale. Cette translation verticale peut être assurée par divers moyens tels qu'un moteur ou un actionneur manuel. Cette translation permet d'améliorer la gestion de la température des surfaces de croissance et leur homogénéité.

De préférence, le module de porte substrat 500 comporte des soufflets 550 aptes à assurer la mobilité en translation verticale du support de croissance 51. Les soufflets 550 sont de préférence situés en dessous du plateau 900.

Le module de porte substrat 500 selon l'invention présente également l'avantage d'être apte à se déplacer en rotation. Cette rotation peut être assurée par divers moyens tels qu'un moteur ou un actionneur manuel. De préférence, le module de porte substrat 500 est lié à un moteur relié à un axe du porte substrat et situé à l'extérieur du volume formé par l'enceinte 400 apte à assurer la mobilité en rotation du support de croissance 51.

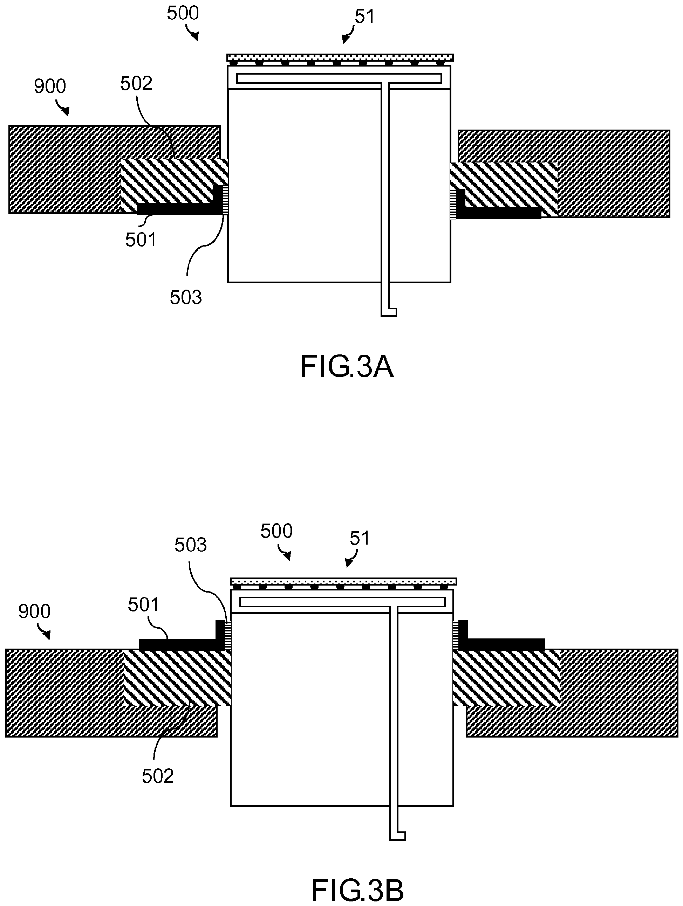

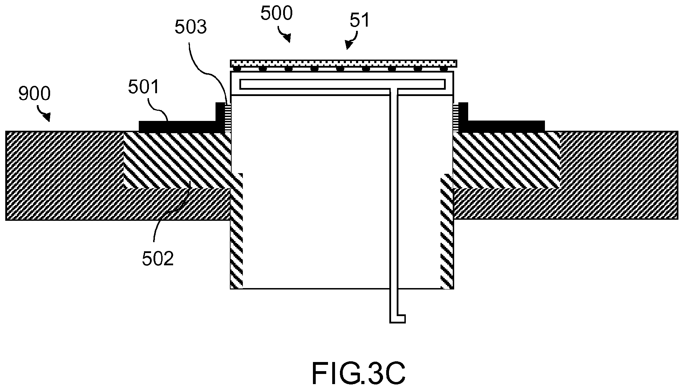

En outre, le module de porte substrat 500 est en contact avec un quart d'onde 501 apte à limiter la propagation des microondes en dehors de la cavité résonante 41. Un quart d'onde 501 est une structure métallique de symétrie cylindrique et formant en coupe longitudinale un quart d'onde. Un quart d'onde 501 selon l'invention est présenté sur la figure 2. Le quart d'onde 501 est en contact direct ou indirect avec le module de porte substrat 500 et de façon préférée, il est connecté électriquement au module de porte substrat 500, de façon encore plus préférée, il est en contact indirect et est connecté électriquement au module de porte substrat 500 par l'intermédiaire d'un moyen conducteur électrique 503. De façon avantageuse, lorsque le réacteur modulaire 1 selon l'invention comporte un plateau 900 et un module de porte-substrat 500, le quart d'onde 501 peut être isolé électriquement du plateau 900 et être connecté électriquement au module de porte substrat 500. L'isolation électrique peut être réalisée par un moyen isolant 502 comportant un matériau isolant électrique et apte à isoler électriquement le plateau 900 du quart d'onde 501 et peut par exemple comprendre un bloc de PTFE (polytétrafluoroéthylène) ou un joint en PTFE. La connexion électrique entre le module de porte substrat 500 et le quart d'onde 501 peut être réalisée par un moyen conducteur 503 comportant un matériau conducteur électrique et apte à conduire le courant électrique entre le module de porte substrat 500 et le quart d'onde 501. La connexion électrique entre le module de porte substrat 500 et le quart d'onde 501 est de préférence réalisée via un moyen conducteur 503 comportant un mélange de cuivre et de béryllium. Des agencements particuliers du quart d'onde 501 au sein du réacteur modulaire 1 sont présentés sur la **figure 3.** Les figures 3A, 3B et 3C montrent que de préférence, le quart d'onde 501 est lié au plateau 900 mobile par l'intermédiaire d'un moyen isolant 502 et qu'il entre en contact avec le module de porte substrat 500 par l'intermédiaire d'un moyen conducteur 503. Le quart d'onde 501 peut être par exemple positionné en dessous (figure 3A) ou au-dessus (figures 3B et 3C) du plateau 900 mobile.

Le module de porte substrat 500 comporte au moins un système de refroidissement fluide 520 apte à faire circuler un fluide caloporteur de refroidissement (e.g. de l'eau) dans le module de porte substrat 500. Ce fluide de refroidissement permet de maîtriser la montée en température du support de croissance 51 et donc du substrat. De préférence, le fluide de refroidissement est un liquide de refroidissement, qui peut par exemple être sélectionné parmi : eau, eau additionnée d'additifs, huile de silicone, ou autres. De préférence, un canal de distribution de fluide 521 est relié à une chambre de distribution 522 apte à répartir le fluide caloporteur sous la surface supérieure du module de porte substrat 500.

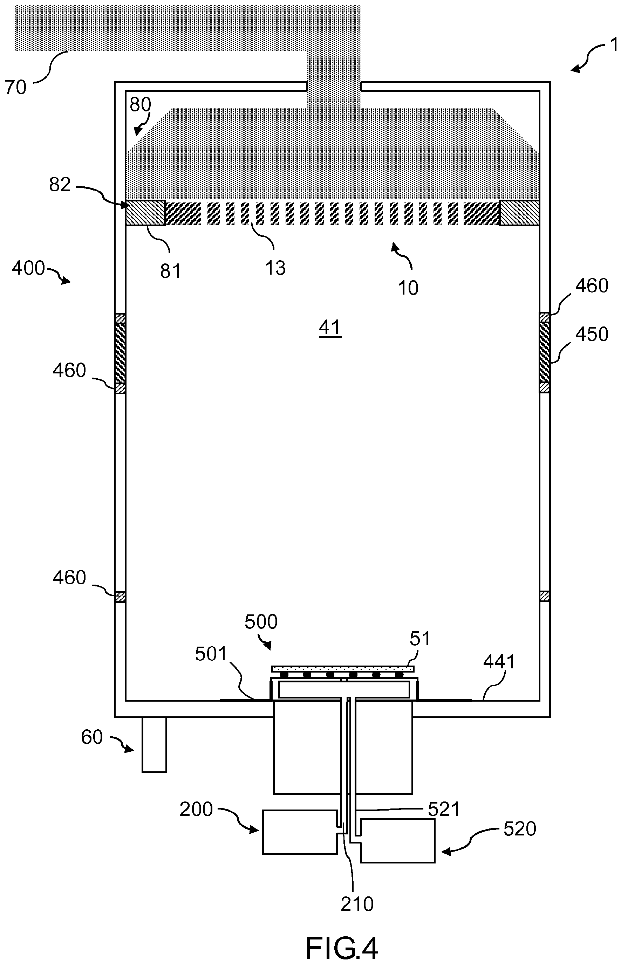

Le refroidissement du support de croissance 51 par un système de refroidissement fluide 520 est nécessaire mais ne permet généralement pas un contrôle suffisamment précis de la température du support de croissance 51 et de la surface de croissance du ou des substrats. Ainsi, comme cela est présenté **sur la figure 4,** le module de porte substrat 500 comporte avantageusement au moins un canal de distribution de gaz 210 relié à un système de gestion des gaz de résistance thermique 200 et apte à distribuer un gaz de résistance thermique à proximité du support de croissance 51.

Le gaz de résistance thermique peut par exemple être un mélange comprenant de l'argon, de l'hydrogène et / ou de l'hélium. L'utilisation de gaz de résistance thermique permet de maîtriser finement la température du support de croissance 51 et du substrat et donc d'optimiser la croissance du diamant.

L'aire de la surface supérieure du porte-substrat, parallèle au support de croissance 51, est comprise entre 5 % et 30 % de l'aire de la section transversale de l'enceinte 400 au niveau du support de croissance 51. Par exemple, dans un réacteur modulaire selon l'invention configuré pour opérer avec des microondes dont la fréquence est comprise entre 900 MHz et 1000 MHz, l'aire de la surface supérieure du porte-substrat, parallèle au support de croissance 51, est comprise entre 50 cm$^2$ et 300 cm$^2$, de préférence entre 50 cm$^2$ et 250 cm$^2$.

Les porte-substrats de l'art antérieur présentent souvent un volume réduit et n'occupent qu'une place réduite dans le réacteur de dépôt. Les présents inventeurs ont développé un module de porte substrat 500 pouvant comporter de nombreuses fonctionnalités et qui présentent un volume important. Grâce à ce volume important, le module de porte substrat 500 selon l'invention peut, lors de son déplacement en translation verticale, engendrer une modification significative de la cavité résonante 41 et donc du plasma. Ce volume important permet également d'héberger les différentes fonctionnalités du porte substrat selon l'invention (e.g. refroidissement par fluide, par gaz de résistance thermique, système de rotation, autre). Ainsi, grâce à son volume et sa capacité à permettre le déplacement en translation verticale du support de croissance 51, un tel module de porte substrat 500 peut être utilisé pour optimiser les paramètres de croissance. Dans un réacteur modulaire selon l'invention configuré pour opérer avec des microondes dont la fréquence est comprise entre 900 MHz et 1000 MHz, de façon préférée, le module de porte substrat 500 présente un volume compris entre 1000 cm$^3$ et 10000 cm$^3$.

De la même façon, de façon préférée, le module de porte substrat 500 présente un diamètre (ou une surface en coupe transversale) constant et sensiblement identique au diamètre (ou à la surface) du support de croissance 51.

En outre, le module de porte substrat 500 peut être éventuellement isolé électriquement de la cavité résonante 41, de l'enceinte 400 et/ou du plateau 900 selon l'invention. Cela permet d'avoir un potentiel électrique différent entre le module de porte-substrat 500 et la cavité résonante 41. De façon plus préférée, le module de porte substrat 500 est électriquement isolé des autres éléments du réacteur 1. Cette caractéristique peut permettre, lors de la mise en oeuvre du réacteur selon l'invention, le déplacement en translation verticale du module de porte-substrat 500 sans engendrer une modification significative de la forme du plasma. Le module de porte-substrat 500 peut par exemple être isolé par l'intermédiaire d'un cylindre percé en PTFE, d'un joint en PTFE ou d'autres matériaux isolants électriques placés entre le module de porte substrat 500 et le plateau 900.

Lorsque le réacteur comprend le module de porte substrat 500 en combinaison avec le plateau 900 alors le plateau 900 peut comporter avantageusement des moyens aptes à isoler électriquement 970 (e.g des joints ou blocs PTFE ou autres matériaux isolants-électriques) permettant d'assurer une isolation électrique entre le porte substrat et le plateau 900. En outre, la base de l'enceinte peut comporter, au niveau de l'ouverture permettant le passage du module de porte substrat 500, un moyen isolant 980 comportant un matériau isolant électrique (e.g. un joint) permettant d'isoler électriquement le module de porte substrat 500 de l'enceinte 400. Avantageusement, la base de l'enceinte comporte, au niveau de l'ouverture permettant le passage du module de porte substrat 500, un système de joints permettant d'isoler électriquement le module de porte substrat 500 de l'enceinte.

De préférence, le moyen permettant d'assurer une isolation électrique est composé de PTFE. Dans ce mode de réalisation, le ou les fluides transitant au sein du porte-substrat ne sont pas ou peu conducteurs. Il est possible d'utiliser par exemple de l'eau dé-ionisée ou de l'huile silicone. Par exemple, la conductivité du fluide est inférieure à 50 μS/cm, de préférence inférieure à 20 μS/cm. Cela permet d'isoler électriquement le plateau 900 et/ou l'enceinte 400 du module de porte-substrat 500 et donc de supprimer son influence sur les caractéristiques du cœur du plasma.

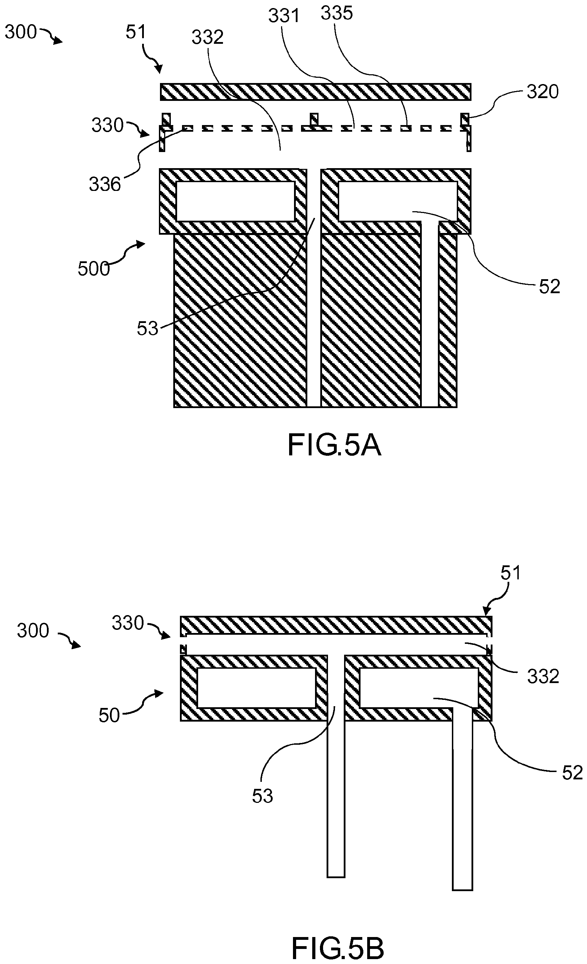

Comme décrit ci-dessus, le module de porte substrat 500 peut comprendre une liaison à un système de gestion des gaz de résistance thermique 200. Afin de maîtriser les conditions de croissance, il est nécessaire de maîtriser les transferts thermiques afin de contrôler au mieux la distribution de la température au niveau du support de croissance 51 et de la surface de croissance. Une zone essentielle de surveillance pour ces transferts thermiques est la zone de croissance du diamant, au niveau du substrat. Or, en fonction de la forme ou de la disposition du substrat ainsi que du résultat à atteindre (e.g. épaisseur, vitesse de croissance, orientation de la croissance) ce n'est pas le même refroidissement qui est attendu au niveau du support de croissance 51. Ainsi, afin de pouvoir contrôler finement le refroidissement au niveau du support de croissance 51, les inventeurs ont mis au point un autre élément modulaire qui consiste en un **module de contrôle du refroidissement du substrat 300,** comprenant un dispositif d'injection de gaz de résistance thermique 330 amovible pouvant être remplacé aisément entre deux croissances et s'adaptant à la croissance escomptée. Ce module de contrôle du refroidissement du substrat 300 est présenté sur les **figures 5A et 5B.** Ce système avantageusement peut être modulé en hauteur au cours de la croissance.

Comme présenté sur la figure 5A, le module de contrôle du refroidissement du substrat 300 comprend un dispositif d'injection de gaz de résistance thermique 330 amovible. Le module de contrôle du refroidissement du substrat 300 permet avantageusement de maintenir la surface de croissance à une température comprise entre 600°C et 1400°C et maîtriser la distribution spatiale du gradient thermique entre la surface de croissance et le porte-substrat. Pour les couches de diamant ultra-nanocristallin des températures de 150°C à 400°C seront recherchées.

**Le dispositif d'injection de gaz de résistance thermique 330** amovible selon l'invention comprend une ou plusieurs entrées de gaz de résistance thermique 333 et une ou plusieurs sorties de gaz de résistance thermique 331. L'entrée de gaz de résistance thermique 333 peut être reliée aux sorties de gaz de résistance thermique 331 par l'intermédiaire d'une chambre de répartition 332.

**L'entrée des gaz de résistance thermique 333** est de préférence située au centre du dispositif d'injection de gaz de résistance thermique amovible 330. Le dispositif d'injection de gaz de résistance thermique amovible 330 peut comprendre plusieurs entrées de gaz de résistance thermique 333. L'existence de plusieurs entrées de gaz de résistance thermique 333 permet de gérer l'utilisation de gaz ou de mélange de gaz de résistances thermiques différents. Par exemple, une entrée est dédiée à un premier gaz de résistance thermique tandis qu'une autre entrée est dédiée à un autre gaz de résistance thermique. Les entrées de gaz de résistance thermique 333 peuvent être reliées à des chambres de répartition 332 différentes. En outre, la présence de plusieurs entrées de gaz de résistance thermique 333 permet d'injecter des gaz différents à des concentrations ou des vitesses réglables de façon indépendante.

L'entrée des gaz de résistance thermique 333 peut présenter, dans un réacteur modulaire selon l'invention configuré pour opérer avec des microondes dont la fréquence est comprise entre 900 MHz et 1000 MHz, un diamètre compris par exemple entre 1 mm et 10 mm. De préférence, l'entrée des gaz de résistance thermique 333 présente un diamètre compris entre 3 mm et 7 mm.

La **chambre de répartition 332** du dispositif d'injection de gaz de résistance thermique 330 amovible permet d'améliorer l'homogénéité de la distribution spatiale des gaz de résistance thermique au niveau du support de croissance 51. Dans un réacteur modulaire selon l'invention configuré pour opérer avec des microondes dont la fréquence est comprise entre 900 MHz et 1000 MHz, le volume de la chambre de répartition 332 peut être compris de préférence, entre 0 mm$^3$ et 16000 mm$^3$. De préférence, le volume de la ou des chambres de répartition 332 est réduit de façon à augmenter le transfert thermique entre le porte substrat et le support de croissance 51. Ainsi, la hauteur de la chambre de répartition 332 est avantageusement très réduite, par exemple elle est comprise entre 0,02 mm et 5 mm, de préférence entre 0,05 mm et 1 mm. De plus, la chambre de répartition 332 peut ne pas comprendre de base comme cela est représenté sur la figure 5A.

Le dispositif d'injection de gaz de résistance thermique amovible 330 peut comprendre plusieurs chambres de mélange.

**La ou les plusieurs sorties de gaz de résistance thermique 331** sont disposées de façon à, de préférence, injecter les gaz de résistance thermique en dessous du support de croissance 51. Elles ont pour objectif de gérer le refroidissement du support de croissance 51 et en conséquence gérer la température de la surface de croissance. Etant donné que ces sorties sont placées sur le dispositif d'injection de gaz de résistance thermique 330 amovible, il est possible grâce à l'invention de faire aisément varier, entre chaque croissance, plusieurs facteurs essentiels à l'optimisation des conditions de croissance et relatifs aux sorties de gaz de résistance thermique comme par exemple : leur nombre, leur orientation et leur densité. La modulation de ces paramètres permet de fournir des caractéristiques de modulation du refroidissement du support de croissance 51 adaptées à la croissance souhaitée.

La distance entre les sorties de gaz de résistance thermique 331 et le support de croissance 51 peut affecter la croissance des couches de diamant. Cette distance peut être égale sur tout le support de croissance 51 et elle peut réduite dans le cas où des températures de croissance relativement faibles sont recherchées. Ainsi, le module de contrôle du refroidissement du substrat 300 peut avantageusement comprendre des **moyens de positionnement 320** pouvant être indépendants ou intégrés au dispositif d'injection de gaz de résistance thermique 330 amovible.

Les moyens de positionnement 320 selon l'invention peuvent prendre différentes formes, telles qu'un hexaèdre par exemple un cube ou un parallélépipède, un prisme, un cylindre.

Dans un réacteur modulaire selon l'invention configuré pour opérer avec des microondes dont la fréquence est comprise entre 900 MHz et 1000 MHz, il est avantageux que les moyens de positionnement 320 selon l'invention présentent une hauteur inférieure à 800 μm, de façon plus préférée inférieure à 500 μm, et de

façon encore plus préférée inférieure à 250 μm. Les moyens de positionnement 320 présentent généralement une hauteur supérieure à 5 μm.

En outre, il est avantageux que, lorsque plusieurs moyens de positionnement 320 sont utilisés selon l'invention, ces moyens présentent une variation de leur hauteur inférieure à 10 %, de préférence inférieure à 5 %, de façon encore plus préférée inférieure à 2 %. En effet dans le cadre de la présente invention, la présence de moyen de positionnement 320 ayant une très faible variation de hauteur entraîne un contrôle plus optimal de la température de la surface de croissance et donc une croissance mieux maîtrisée.

De façon alternative, ces moyens de positionnement 320 peuvent présenter avantageusement des différences de hauteur significatives permettant de moduler les caractéristiques de refroidissement des surfaces de croissance. Il est néanmoins souhaitable que le support de croissance 51 soit positionné de façon parallèle à la surface de la base de l'enceinte 441.

Ces moyens de positionnement 320 peuvent être amovibles et peuvent avantageusement être maintenus en position par rapport au support de croissance 51 par l'intermédiaire d'évidements dans la surface inférieure du support de croissance 51 telles que des encoches. Ainsi, le support de croissance 51 peut comporter sur sa surface inférieure des évidements aptes à accueillir des moyens de positionnement 320. Ces évidements présentent une aire de section transversale comprise de préférence entre 0,5 cm$^2$ et 5 cm$^2$, une profondeur inférieure à 1 cm de préférence inférieure à 5 mm. Ainsi, le support de croissance 51 peut comprendre entre 3 et 30 évidements, de préférence entre 3 et 15, et de façon plus préférée entre 3 et 7 évidements. Ces évidements peuvent présenter différentes formes de section transversale (par exemple circulaire, rectangulaire, carrée).

En outre, ces moyens de positionnement 320 peuvent être mobiles en translation verticale et être associés à un moyen de translation verticale permettant un déplacement lent et précis de ces moyens de positionnement 320. Ce déplacement en translation verticale a pour objectif de moduler la distance entre le support de croissance 51 et le dispositif d'injection des gaz de résistance thermique 330 ou le module de porte substrat 500 ou le porte substrat 50. Le moyen de translation verticale peut per exemple être sélectionné parmi des moyens tels que des vérins, des soufflets ou des actuateurs. Cette mobilité verticale permet de faire évoluer en cours de croissance la distance entre le dispositif d'injection des gaz de résistance thermique 330 et le support de croissance de façon à ajouter un niveau supplémentaire de contrôle sur la température de la ou des surfaces de croissance.

Les moyens de positionnement 320 selon l'invention peuvent être constitués d'une grande diversité de matériaux, par exemple en métal, matériau diélectrique ou graphite ou autre, de grande pureté ou en multi-couches.

Le dispositif d'injection de gaz de résistance thermique amovible 330 peut avantageusement présenter une hauteur réduite de façon à accroître le transfert thermique entre le système de refroidissement du porte substrat et le support de croissance 51. Ainsi, de façon préférée le dispositif d'injection de gaz de résistance thermique amovible 330 présente une hauteur inférieure à 1 mm, de façon plus préférée inférieure à 100 μm. En outre, ces hauteurs peuvent être modulables en fonction de l'épaisseur du support de croissance 51.

En effet, de façon avantageuse, le dispositif d'injection de gaz de résistance thermique amovible 330 est configuré de telle façon à ce que la distance entre le dispositif d'injection de gaz de résistance thermique amovible 330 et le porte substrat 50 (ou le module de porte substrat 500) soit inférieure à 200 μm, de préférence inférieure à 50 μm et de façon encore plus préférée inférieure à 10 μm. Ils peuvent également être configurés de façon à ce que le dispositif 330 et le porte substrat 50 soient en contact sur une surface au moins égale à la surface du support de croissance 51.

Comme cela est présenté sur la figure 5B, le dispositif d'injection de gaz de résistance thermique amovible 330 peut intégrer le support de croissance 51. Cela a pour avantage d'améliorer les échanges thermiques et donc d'assurer un meilleur refroidissement du ou des substrats. Cette configuration permet, notamment, en éliminant une partie des espaces creux pouvant exister entre le porte-substrat 50 et le support de croissance 51, d'optimiser le contrôle thermique de la surface supérieure du support de croissance 51.

Par exemple, le module de contrôle du refroidissement du substrat 300 permet de mettre en oeuvre un procédé où les gaz de résistance thermique sont éjectés du système de refroidissement vers la cavité résonante 41 à un débit total de gaz d'au moins 20 sccm de préférence au moins 50 sccm.

Le module de contrôle du refroidissement du substrat 300, selon l'invention peut être utilisé avantageusement en combinaison avec le module de porte substrat 500 selon l'invention mais il peut également être utilisé avec des porte-substrats classiques. En effet, les porte-substrats classiques peuvent comprendre une ou plusieurs sorties de gaz de résistance thermique dans lesquelles pourrait s'adapter le module de contrôle du refroidissement du substrat 300 selon l'invention.

Le dispositif d'injection de gaz de résistance thermique 330 amovible donne aux utilisateurs la possibilité de moduler finement la distribution des gaz de résistance thermique et de l'adapter aux conditions de croissance des couches de diamant souhaitées. En effet, lors de la croissance de diamant, la gestion de la température au niveau du substrat doit être adaptée en fonction de la position du ou des substrats dans la cavité résonante 41, de la composition de gaz utilisée pour la croissance, des conditions de pression et de puissance, du nombre de substrats de diamant en croissance (ou de la dimension de la couche de diamant polycristallin), des caractéristiques des couches de diamants (polycristallin, monocristallin) en croissance et de la durée anticipée de la réaction de croissance. Ce dispositif dans ce contexte est particulièrement utile dans le cadre de l'optimisation des conditions de croissance.

En outre, les sorties de gaz de résistance thermique 331 présentent l'avantage d'une distribution du gaz de résistance thermique de façon à obtenir une distribution de température du substrat optimale sur toute la surface de croissance. Néanmoins, ils présentent l'inconvénient de pouvoir s'encrasser. L'existence d'un tel dispositif d'injection de gaz de résistance thermique 330 amovible rend possible un remplacement de cette pièce sans avoir à remplacer tout un ensemble de pièces reliées à un tel module de refroidissement.

Les inventeurs ont également optimisé la distribution des sorties au sein du dispositif d'injection de gaz de résistance thermique 330 amovible de façon à permettre une distribution des gaz optimale vis-à-vis de la croissance du ou des monocristaux de diamant, ou d'une couche de diamant polycristallin. L'avantage de l'utilisation d'un dispositif d'injection de gaz de résistance thermique 330 amovible est qu'il est possible de faire varier plusieurs paramètres tels que **les dimensions des sorties ou la densité des sorties.**

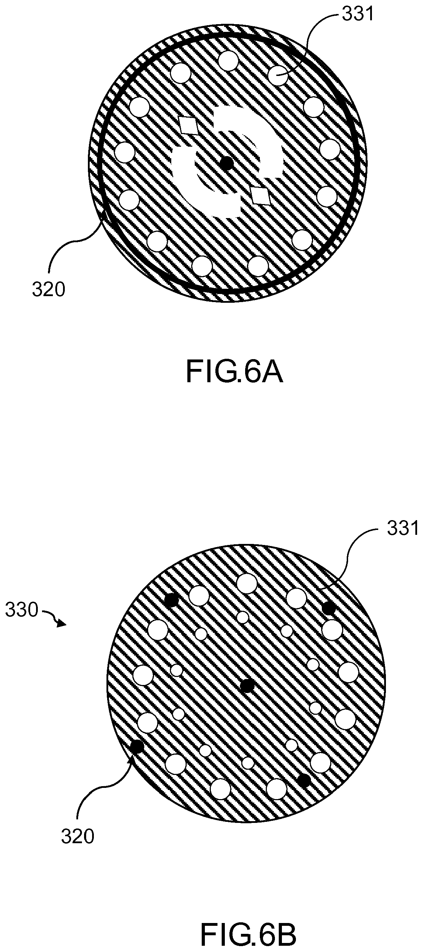

Comme cela est présenté sur la **figure 6A,** les sorties de gaz de résistance thermique 331 peuvent présenter différentes formes. Par exemple, la section transversale des sorties 331 peut présenter une forme de cercle, carré, rectangle, losange. La forme de cette section peut varier entre deux sorties 331 mais également au sein d'une même sortie 331 en fonction du fait qu'est considérée la section de la sortie 331 sur la surface interne 336 ou sur la surface externe 335 du dispositif d'injection de gaz de résistance thermique amovible 330. De préférence, la section des sorties 331 présente une forme de cercle.

Comme cela est présenté sur la **figure 6B,** les sorties de gaz de résistance thermique 331 peuvent présenter différentes surfaces de section. Par exemple, la section totale des sorties 331 peut présenter une aire comprise entre 5 % et 15 % de l'aire du support de croissance 51. La surface de cette section peut varier entre deux sorties 331 mais également au sein d'une même sortie 331 en fonction du fait qu'est considérée la section de la sortie 331 sur la surface interne 336 ou sur la surface externe 335 du dispositif d'injection de gaz de résistance thermique amovible 330.

Dans un réacteur modulaire selon l'invention configuré pour opérer avec des microondes dont la fréquence est comprise entre 900 MHz et 1000 MHz, chaque sortie de gaz de résistance thermique 331 peut présenter un diamètre, sur la surface interne 336 du dispositif d'injection de gaz de résistance thermique amovible 330, compris entre 0,2 mm et 5 mm, de préférence compris entre 0,5 mm et 3 mm.

Dans un réacteur modulaire selon l'invention configuré pour opérer avec des microondes dont la fréquence est comprise entre 900 MHz et 1000 MHz, chaque sortie de gaz de résistance thermique 331 peut présenter un diamètre, sur la surface externe 335 du dispositif d'injection de gaz de résistance thermique amovible 330, compris entre 0,5 mm et 3 mm.

Les diamètres des sorties de gaz de résistance thermique 331, que cela soit sur la surface interne 336 ou externe 335 du dispositif d'injection de gaz de résistance thermique 330 peuvent être configurés de manière à obtenir une distribution optimale du ou des gaz de résistance thermique sur toute la surface équivalente au support de croissance 51.

En outre, au sein d'un même dispositif d'injection de gaz de résistance thermique amovible 330, les diamètres des sorties de gaz de résistance thermique 331, que cela soit sur la surface interne 336 ou externe 335 du dispositif d'injection de gaz de résistance thermique amovible 330, peuvent être égaux mais ils peuvent également varier en fonction de la position de la sortie au sein du dispositif d'injection de gaz de résistance thermique amovible 330 par rapport à l'axe de symétrie du réacteur.

Le dispositif d'injection de gaz de résistance thermique amovible 330 selon l'invention permet de faire varier aisément la densité de sorties et de fournir un réseau modulable de sorties de gaz de résistance thermique 331.

Ainsi, par exemple, le dispositif d'injection de gaz de résistance thermique amovible 330 comprend une densité de sorties de gaz de résistance thermique 331 d'au moins 1 sortie / cm$^2$. La densité des sorties de gaz de résistance thermique 331 est mesurée en divisant le nombre de sorties présentes sur le dispositif d'injection de gaz de résistance thermique amovible 330 par la surface du dispositif d'injection faisant face au support de croissance 51. Le dispositif d'injection de gaz de résistance thermique amovible 330 peut comprendre une densité de sorties très supérieure à 1 sortie / cm$^2$. En effet, une densité élevée de sorties permet d'optimiser le flux de gaz de résistance thermique en cours d'utilisation et permet ainsi à la température du ou des substrats d'être modulée afin d'obtenir la formation uniforme en épaisseur d'un film de diamant homogène à des vitesses élevées sur une surface relativement importante. Ainsi, dans un réacteur modulaire selon l'invention configuré pour opérer avec des microondes dont la fréquence est comprise entre 900 MHz et 1000 MHz, de préférence, le dispositif d'injection de gaz de résistance thermique amovible 330 comprend des sorties de gaz de résistance thermique 331 à une densité moyenne comprise entre 0,1 et 5 sorties par cm$^2$, de façon plus préférée une densité comprise entre 0,1 et 3 sorties par cm$^2$, de façon encore plus préférée une densité comprise entre 0,2 et 2 sorties par cm$^2$. Outre cette modularité possible de densité de sorties de gaz de résistance thermique 331 permettant de moduler la distribution de gaz de résistance thermique entre chaque expérimentation, l'utilisation de plusieurs entrées de gaz de résistance thermique 333 et/ou chambres de répartition 332, permet de moduler la distribution de gaz de résistance thermique en cours d'expérimentation.

Avec une telle densité de sorties de gaz de résistance thermique 331, le dispositif d'injection de gaz de résistance thermique amovible 330 peut comprendre au moins 5, par exemple au moins 10, de préférence au moins 20, de façon préférée au moins 50 sorties.

La surface externe supérieure du dispositif d'injection de gaz de résistance thermique amovible 330, c'est-à-dire la surface au plus proche du support de croissance 51 peut prendre plusieurs formes telles qu'un cercle, un carré, un rectangle, une ellipse, une portion de cercle. De préférence, la forme de la surface externe supérieure du dispositif d'injection de gaz de résistance thermique amovible 330 est sensiblement identique à la forme du support de croissance 51.

Tout comme pour le diamètre des sorties, la densité des sorties au sein d'un même dispositif d'injection de gaz de résistance thermique amovible 330 peut varier en fonction de l'emplacement au sein du dispositif d'injection 330.

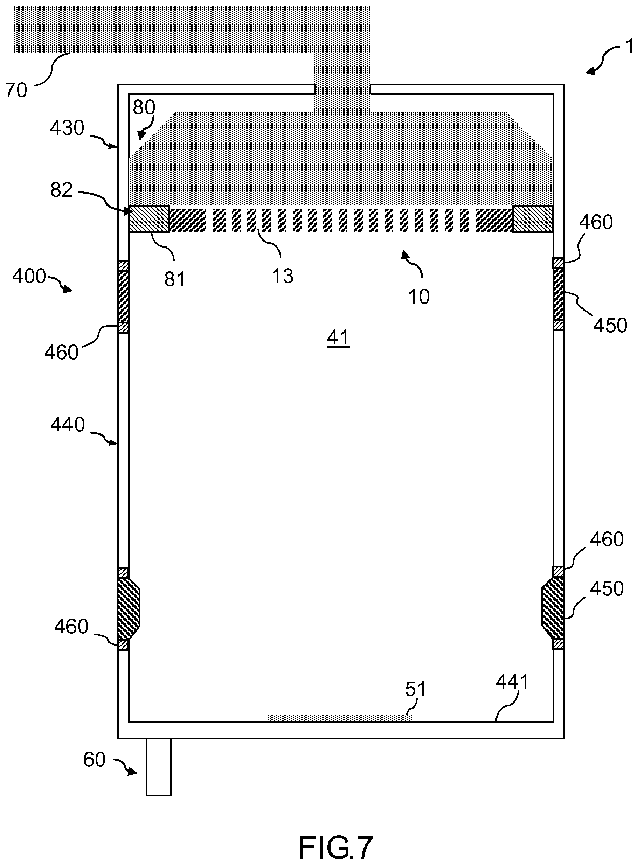

Un autre des éléments de modulation proposés par les inventeurs est une **couronne 450** apte à être positionnée entre une première partie d'enceinte 430 et une deuxième partie d'enceinte 440 de façon à modifier la forme et/ou le volume de la cavité résonante 41. En outre, la ou les couronnes 450 selon l'invention peuvent présenter de nombreuses fonctions additionnelles telles que par exemple la modification de la forme ponctuelle de la cavité résonante 41, des injections de gaz, des fenêtres pour l'observation de la croissance, la mesure de la température et/ou les analyses de substrats (e.g. hauteur, couleur). Une couronne 450 est présentée sur la **figure 7.** Le réacteur modulaire 1 selon l'invention peut comprendre une ou plusieurs couronnes 450 et de façon préférée une ou deux couronnes 450. Comme cela est présenté sur la figure 7, ces couronnes 450 peuvent être positionnées à différentes hauteurs de l'enceinte 400 et de préférence au niveau de la cavité résonante 41. En outre, une couronne 450 selon l'invention peut permettre l'injection de gaz de croissance et/ou de résistance thermique.

Comme cela est présenté sur la figure 7, la couronne 450 permet de faire varier la géométrie de la cavité résonante 41 et par exemple augmenter la hauteur entre le guide d'onde 82 et la base 441 de l'enceinte 400. Cet élément modulaire peut permettre d'optimiser les distributions spatiales de la température du gaz et de la densité de H atomique dans le plasma de sorte à les optimiser à l'interface plasma / surface. Cette modularité est de préférence couplée à la modularité apportée par le plateau 900 de façon à donner à l'utilisateur une grande latitude de dimension de façon à adapter la configuration de la cavité résonante 41 à la croissance souhaitée. Pour cette application, de préférence, la couronne 450 est une couronne métallique. Elle peut, par exemple, comprendre ou être constituée d'aluminium ou d'un alliage d'aluminium.

La première partie d'enceinte peut par exemple comporter le système d'arrivée des gaz et le module de couplage des ondes. La deuxième partie d'enceinte peut par exemple comporter le module de sortie des gaz et le support de croissance. Lorsque le réacteur modulaire 1 selon l'invention comporte deux couronnes alors de façon préférée une couronne 450 est apte à être positionnée entre une première partie d'enceinte 430 et une troisième partie d'enceinte 470 et une couronne 450 est apte à être positionnée entre une deuxième partie d'enceinte 440 et une troisième partie d'enceinte 470.

Alternativement, la couronne 450 peut comprendre ou être constituée d'un matériau diélectrique tel que le quartz. En effet, la couronne 450 comprenant ou étant constituée de quartz permet d'observer la croissance et les dépôts successifs des couches de diamant. Ainsi, de façon avantageuse, la couronne 450 comprend un matériau diélectrique par exemple sous la forme de fenêtre d'observation diélectrique (e.g. des hublots). La couronne 450 peut également être constituée de 20% à 80 % de matériau diélectrique. Le matériau diélectrique peut prendre la forme d'une fenêtre annulaire ou bien être intégré à la couronne 450 sous la forme d'une fenêtre plane pouvant prendre différentes formes (e.g. rectangle, carré, cercle).

La couronne 450 peut comprendre un moyen d'injection de gaz, de préférence radial. Ce moyen d'injection peut permettre l'injection de gaz tel que l'argon ou bien l'injection de gaz dopants ou du méthane à proximité du support de croissance 51.

La première partie d'enceinte 430 englobe de préférence le système d'arrivée des gaz 10 et le module de couplage des ondes 80. La deuxième partie d'enceinte 440 englobe de préférence le module de sortie des gaz 60 et le support de croissance 51.

Le système de joints 460 est disposé entre la couronne 450 et respectivement, la première partie d'enceinte 430 et la deuxième partie d'enceinte 440. Le système de joints 460, permet l'étanchéité du point de vue du vide et assure la continuité électrique des parois de l'enceinte. Le système de joints 460 peut comprendre plusieurs joints pouvant être constitués de matériaux similaires ou différents et, par exemple, comprendre les matériaux sélectionnés parmi le cuivre, le Béryllium, une combinaison de Cuivre-Béryllium ou encore une pâte contenant des particules de métal telles que d'argent par exemple. De façon préférée, le système de joints 460 comporte du Béryllium et de préférence un mélange de Cuivre-Béryllium. Ce joint peut prendre différentes formes comme par exemple celle d'une tresse métallique ou une pâte contenant des particules métalliques, des particules d'argent par exemple. Le système de joints 460 peut également comprendre un polymère fluoré tel que du Viton de façon à assurer une étanchéité au vide. Le système de joints 460 assurant la conductivité électrique des parois de l'enceinte et l'étanchéité de la cavité résonante 41 peut reposer sur un premier joint ou un ensemble de joints utilisé pour associer la première partie d'enceinte 430 et la deuxième partie d'enceinte 440 ainsi qu'un second joint ou un ensemble de joints associé à la couronne 450.

La couronne 450 peut présenter une large gamme d'épaisseur et de hauteur. De préférence, dans un réacteur modulaire selon l'invention configuré pour opérer avec des microondes dont la fréquence est comprise entre 900 MHz et 1000 MHz, la couronne 450 présente une hauteur comprise entre 1 cm et 20 cm, de façon plus préférée, la couronne 450 présente une hauteur comprise entre 1 cm et 10 cm, de façon encore plus préférée la couronne 450 présente une hauteur comprise entre 3 cm et 10 cm.

De préférence, la couronne 450 est apte à être positionnée entre le coupleur 80 et la base 441 de l'enceinte ou le plateau 900. La couronne 450 étant destinée à être insérée entre une première partie d'enceinte 430 et une deuxième partie d'enceinte 440, elle peut reprendre sensiblement la forme des parois internes et externes de l'enceinte 400. Cette couronne 450 peut prendre la forme d'un anneau si l'enceinte 400 est cylindrique.

De préférence, dans un réacteur modulaire selon l'invention configuré pour opérer avec des microondes dont la fréquence est comprise entre 900 MHz et 1000 MHz, la couronne 450 présente une épaisseur comprise entre 1 cm et 10 cm. De façon plus préférée, la couronne 450 présente une épaisseur comprise entre 3 cm et 10 cm. Selon un mode de réalisation, la couronne 450 présente une épaisseur constante sur toute sa hauteur et est par exemple similaire à l'épaisseur les parois de l'enceinte 400. Alternativement, la couronne 450 peut présenter une épaisseur variable sur sa hauteur et notamment une épaisseur plus importante que l'épaisseur des parois de l'enceinte. Ainsi, dans cette condition, la couronne 450 est apte à induire une déformation de la cavité résonante 41 comme cela est présenté sur la figure 7. Lorsque la couronne 450 est utilisée pour induire une déformation de la cavité résonante 41, elle est de préférence placée à proximité du support de croissance 51.

De préférence, la couronne 450 est apte à être positionnée entre deux parties d'enceinte ayant des formes de section transversale sensiblement identiques, de façon plus préférée, identiques. Alternativement, la couronne 450 est apte à être positionnée entre deux parties d'enceinte ayant des formes de section transversale différentes et elle permet alors de réaliser une jonction entre ces deux parties d'enceinte de formes différentes.

Outre la possibilité, grâce à cet élément modulaire, de faire varier les dimensions de la cavité résonante 41 et donc les paramètres de la croissance, cette couronne 450 peut être reliée à un système de refroidissement 600 configuré pour la refroidir indépendamment de la première partie d'enceinte 430 et de la deuxième partie de l'enceinte 440. Ainsi, la couronne 450 peut être placée au niveau de la hauteur de formation du plasma et bénéficier d'un refroidissement plus fort que les autres parties de l'enceinte. Cet élément modulaire permet alors d'adapter le refroidissement aux besoins réels du réacteur 1.

Ainsi, de préférence, la couronne 450 est reliée à un système de refroidissement configuré pour la refroidir indépendamment de la première partie d'enceinte 430 et/ou de la deuxième partie de l'enceinte 440. De façon plus préférée, le système de refroidissement 600 est configuré pour induire une diminution de température plus importante sur la couronne 450 que sur la première partie 430 et/ou sur la deuxième partie 440 de l'enceinte 400. Le système de refroidissement 600 peut également être configuré pour refroidir indépendamment le module de couplage 80.

La couronne 450 peut cumuler plusieurs fonctions simultanément par exemple rehausser la cavité, injecter des gaz et apporter un renflement métallique dans une partie adéquate de la cavité résonante 41 ou au contraire une déformation vers l'extérieur.

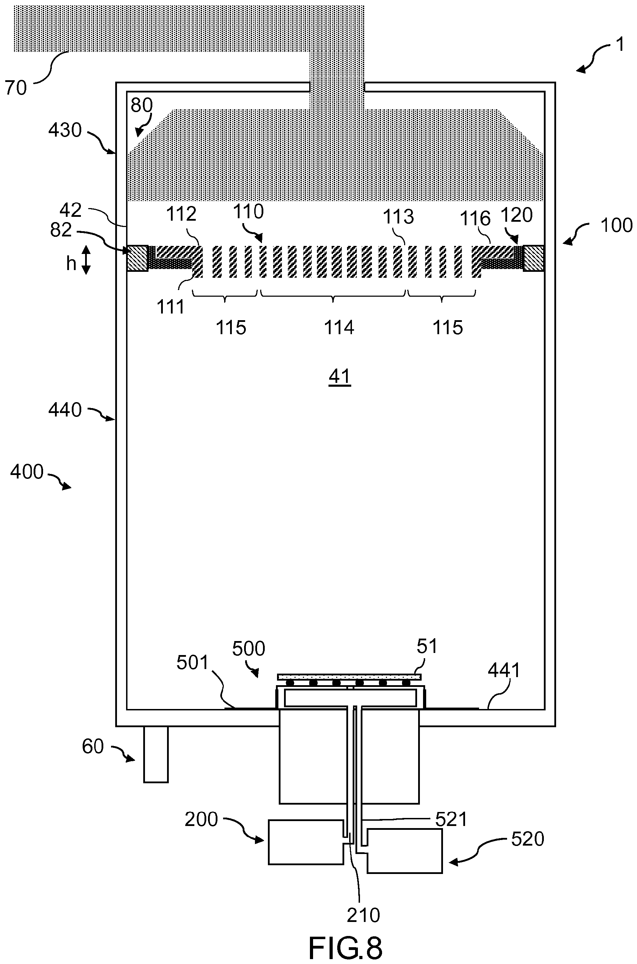

La **figure 8** représente un réacteur à plasma micro-onde semblable à celui représenté sur la figure 1. L'agencement représenté sur la figure 8 diffère en ce qu'il comprend un module de porte substrat 500 et que le système d'entrée de gaz 10 comprend **un module de distribution des gaz 100.**

Ce module de distribution des gaz 100 comporte une plaque de distribution des gaz amovible 110 comprenant une surface interne 111, une surface externe 112 et une pluralité de buses de distribution des gaz 113 formant des canaux entre les dites surfaces 111, 112 aptes à conduire un flux de gaz vers un support de croissance 51. Ce module de distribution de gaz 100 est un élément modulaire selon l'invention, ainsi, il permet de faire varier aisément et entre chaque croissance plusieurs facteurs essentiels à l'optimisation des conditions de croissance :

- le nombre de buses d'entrée de gaz,
- l'orientation des buses, et
- la densité de buses.

La modulation de ces paramètres permet de fournir de bonnes caractéristiques d'écoulement de gaz créant un écoulement laminaire du flux de gaz. Comme cela est représenté sur la figure 8, la face interne 111 de la plaque de distribution des gaz amovible 110 correspond à la face orientée vers la cavité résonante 41 et formant partiellement cette dernière.

En outre, ce module de distribution des gaz 100 comprend un dispositif support 120 apte à accueillir la plaque de distribution des gaz amovible 110. Ce dispositif support 120 est relié à un système de refroidissement, de préférence un système de refroidissement par fluide. Ce couplage permet d'établir un pont thermique rendant possible un refroidissement de la plaque de distribution des gaz amovible 110. La plaque de distribution des gaz amovible 110 peut être posée sur un dispositif support 120 mais elle peut également être positionnée de façon à ce que le dispositif support 120 soit au-dessus de la plaque de distribution des gaz amovible 110 ou encore de façon à ce que le dispositif support 120 entoure la plaque de distribution des gaz amovible 110.

Ce module de distribution de gaz 100 donne aux utilisateurs la possibilité de moduler finement la distribution de gaz et de l'adapter aux conditions de croissance des couches de diamant souhaitées. En effet, lors de la croissance de diamant, la distribution du gaz dans la cavité résonante 41 doit être adaptée en fonction de la position du ou des substrats, du nombre de substrats, de la forme du ou des substrats, et de la durée anticipée de la réaction. Ce module dans ce contexte est particulièrement utile dans le cadre de l'optimisation des conditions de croissance. Par exemple, la mise en oeuvre d'un réacteur de dépôt comprenant le module de distribution de gaz 100 selon l'invention dans un procédé de croissance de diamant peut permettre la synthèse d'un gros diamant monocristallin ayant une concentration sensiblement uniforme de dopant ou bien la croissance d'un plus grand nombre de monocristaux de diamant cultivés en un seul passage (une expérimentation) ou encore une couche de diamant polycristallin. Le module de distribution de gaz 100 est de préférence maintenu à la partie centrale du système de guide d'onde, refroidi.

En outre, les buses de distribution de gaz classiques présentent l'avantage d'une distribution quasi-homogène du gaz mais présentent l'inconvénient de pouvoir s'encrasser. L'existence d'un tel module de distribution rend possible le remplacement de la plaque de distribution des gaz amovible 110 sans avoir à remplacer tout un ensemble de pièces reliées à un tel module.

Les inventeurs ont également optimisé la distribution des buses au sein du module amovible de façon à permettre une distribution des gaz optimale et modulaire vis-à-vis de la croissance du ou des substrats de diamant monocristallin ou d'un wafer de diamant polycristallin.

Cette plaque de distribution des gaz amovible 110 est de préférence positionnée de façon sensiblement parallèle au support de croissance 51.

L'avantage de l'utilisation d'une plaque de distribution des gaz amovible 110 est qu'il est possible de faire varier de nombreux paramètres tels que le diamètre des buses, la densité des buses, l'orientation des buses et/ou, en cours de croissance, les gaz injectés.

Dans un réacteur modulaire selon l'invention configuré pour opérer avec des microondes dont la fréquence est comprise entre 900 MHz et 1000 MHz, le diamètre des buses de distribution des gaz 113, sur la surface interne 111 de la plaque de distribution des gaz amovible 110, peut être compris entre 0,1 mm et 3 mm. De préférence, les buses de distribution des gaz 113 peuvent présenter un diamètre, sur la surface interne 111 de la plaque de distribution des gaz amovible 110, compris entre 0,2 mm et 2 mm.

En outre, au sein d'un même module de distribution de gaz 100, le diamètre des buses peut être homogène mais il peut également varier en fonction de la position de la buse au sein de la plaque de distribution des gaz amovible 110 par rapport à l'axe de symétrie du réacteur.

Dans un réacteur modulaire selon l'invention configuré pour opérer avec des microondes dont la fréquence est comprise entre 900 MHz et 1000 MHz, de façon préférée, la surface disponible pour placer des buses est de 500 à 650 cm$^2$. La somme des surfaces, sur la surface interne 111 de la plaque de distribution des gaz amovible 110, des buses de distribution des gaz 113 peut présenter un pourcentage de la surface interne compris entre 1 % et 20 %. Chacune des buses de distribution des gaz 113 pouvant représenter une surface comprise entre 10$^{-2}$ mm$^2$ et 30 mm$^2$.

Alternativement, la surface occupée par les buses de distribution des gaz 113 situées dans une partie centrale 114 de la plaque de distribution des gaz amovible 110 présente un pourcentage de la surface interne 111 de la plaque de distribution des gaz amovible 110 compris entre 20 % et 50 % alors que la surface occupée par les buses de distribution des gaz 113 situées dans une partie périphérique 115 de la plaque de distribution de gaz amovible 110 présentent un pourcentage de la surface interne 111 de la plaque de distribution des gaz amovible 110 compris entre 50 % et 20 %.

De petites buses sont avantageuses pour fournir des flux de gaz à haute vitesse dirigée. Cependant, de telles buses peuvent se colmater plus facilement entraînant une perturbation dans le débit de gaz et donc une perturbation du dépôt uniforme d'un film de diamant sur une surface relativement importante. Ici, étant donné que la plaque de distribution des gaz amovible est amovible, elle peut comprendre des buses de petit diamètre et en cas de colmatage cette plaque pourra être remplacée rapidement et à moindre coût. Ainsi, de façon particulière, la plaque de distribution des gaz amovible 110 peut comprendre des buses de distribution des gaz 113 ayant un diamètre inférieur à 8 mm, de préférence inférieur à 5,5 mm, de façon plus préférée inférieur à 3 mm. De plus, la plaque de distribution des gaz amovible 110 selon l'invention peut être composée d'une plaque poreuse, telle que de la céramique poreuse.

Contrairement aux systèmes de distribution de gaz classiques, le module de distribution de gaz selon l'invention permet de faire varier aisément la densité de buses et de fournir un réseau modulable de buses de distribution de gaz 113.

Ainsi, par exemple, la plaque de distribution des gaz amovible 110 comprend une densité de buse de distribution de gaz 113 d'au moins 0,1 buses / cm$^2$.

La densité des buses de distribution de gaz 113 est mesurée en divisant le nombre de buse présentent sur la plaque distribution de gaz 110 par la surface exprimée en cm$^2$ de la plaque de distribution des gaz amovible 110 faisant face à la cavité résonante 41.

Le réseau peut comprendre une densité de buses d'entrée de gaz très supérieure à 0,1 buses/cm$^2$. En

effet, il a été constaté que fournir une densité relativement élevée de buses permet la formation d'un film de diamant uniforme sur une surface relativement importante. Ainsi, dans un réacteur modulaire selon l'invention configuré pour opérer avec des microondes dont la fréquence est comprise entre 900 MHz et 1000 MHz, de préférence, la plaque de distribution de gaz amovible 110 comprend des buses de distribution de gaz 113 à une densité comprise entre 0,2 et 4 buses par cm$^2$.

Avec une telle densité de buses de distribution de gaz 113, la plaque de distribution de gaz amovible 110 peut comprendre au moins 10 buses, par exemple au moins 30 buses, de préférence au moins 50 buses, de façon préférée au moins 100 buses, de façon plus préférée au moins 200 buses et de façon encore plus préférée au moins 500 buses de distribution de gaz 113. En particulier, la partie centrale 114, peut comprendre une plus forte densité de buses de distribution de gaz 113.

La partie centrale 114 peut prendre plusieurs formes telles qu'un cercle, un carré, un rectangle, ou une ellipse. De préférence, la forme de la partie centrale 114 est sensiblement identique à la forme du support de croissance 51.

Tout comme pour le diamètre des buses, la densité des buses au sein d'une même plaque de distribution des gaz amovible 110 peut varier. Par exemple, l'espacement des buses peut augmenter avec le rayon, de telle sorte que la densité des buses diminue vers le bord extérieur de la matrice. Il est possible d'avoir un réseau aléatoire de buses qui fournit une certaine densité moyenne raisonnablement uniforme des buses pour effectuer une performance adéquate et réaliser certains des avantages de cette invention.

Les orientations des buses de distribution de gaz 113 peuvent être identiques pour toutes les buses au sein de la plaque de distribution de gaz amovible 110 ou bien elles peuvent également varier au sein d'une même plaque. Les orientations des buses de distribution de gaz 113 sont préférablement sensiblement parallèles à l'axe central de la cavité résonante 41. Les buses de distribution des gaz 113 peuvent être orientées de façon à ce que le flux de gaz forme un angle sensiblement orthogonal avec le support de croissance 51.

Les buses de distribution des gaz 113 peuvent être orientées de façon à ce que le flux de gaz forme un angle avec le support de croissance 51 comprise entre 60° et 120°.

Les orientations des buses de distribution de gaz 113 peuvent être variables en fonction de leur position au sein de la plaque de distribution des gaz amovible 110. Elles peuvent être orientées vers l'intérieur ou vers l'extérieur. Il peut être avantageux d'orienter certaines des buses de distribution de gaz 113 vers l'intérieur dans une configuration convergente afin de former un film de diamant plus uniforme ou lorsque qu'un substrat non plan est utilisé. En effet, l'orientation particulière des buses peut permettre de modifier la distribution spatiale de certaines espèces dans le plasma ce qui peut être avantageux pour la croissance sur un substrat non plan. Cela s'applique également pour une orientation divergente.

Ainsi, de façon particulière, les buses de distribution des gaz 113 situées dans une partie centrale 114 de la plaque de distribution des gaz amovible 110 sont orientées de façon à ce que le flux de gaz forme un angle avec le support de croissance 51 compris entre 80° et 100° alors que les buses de distribution de gaz 113 situées dans une partie périphérique 115 de la plaque de distribution des gaz amovible 110 sont orientées de façon à ce que le flux de gaz forme un angle avec le support de croissance 51 compris entre 60° et 80 ° ou 100° et 120°.

La partie centrale 114 de la plaque de distribution des gaz amovible 110 correspond à une surface pouvant être délimitée par un cercle dont le centre est positionné au centre de la plaque de distribution des gaz amovible 110 et dont le diamètre est sensiblement égal à la moitié du diamètre de la plaque de distribution de gaz amovible 110.

Les inventeurs ont déterminé une distribution optimale des diamètres des buses 113 en fonction de la position i de la buse sur le rayon de la plaque de distribution des gaz amovible 110 par rapport à l'axe de symétrie du réacteur.

Cette distribution répond à l'équation :

$$\Phi_i = \Phi_0 + y * i$$

avec :

Φ$_i$ étant le diamètre de la buse numérotée i,
Φ$_0$ étant le diamètre de la buse centrale,
i étant le numéro de la buse sur un rayon de la plaque de distribution des gaz amovible, la numérotation partant du centre de la plaque de distribution des gaz amovible 110 vers ses extrémités, i variant entre 0 et 60, pour un réacteur modulaire 1 configuré pour opérer entre 900 et 1000 MHz,
y variant entre 0,05 et 0,3, pour un réacteur modulaire 1 configuré pour opérer entre 900 et 1000 MHz.

Cette distribution permet d'obtenir de meilleures performances qu'un réseau comportant des buses de même diamètre ou de diamètre aléatoire.

Lors de certaines croissances, au moins trois gaz différents pourront être injectés dans la cavité résonante 41. La distribution de ces gaz lors de leur entrée dans la cavité résonante 41 est importante pour une croissance homogène et rapide. Ainsi, de façon avantageuse, la plaque de distribution des gaz amovible 110 comprend une chambre 117 formant une chambre de dispersion apte à favoriser le mélange et permet le contrôle de la distribution des gaz. La chambre 117 peut fonctionner comme une chambre de mélange pour mélanger les gaz de source avant l'injection dans la chambre à plasma. Un tel mélange avant l'injection dans la chambre à plasma permet d'améliorer l'efficacité du gaz de mélange. En outre, cette chambre 117 permet d'améliorer l'écoulement de gaz uniforme sur la totalité du réseau de buses de gaz et cela notamment lors de faibles débits de gaz.

De façon particulière, le diamètre d'une buse de distribution des gaz 113 sur la face interne n'est pas le même que le diamètre de la même buse sur sa face externe de la plaque de distribution des gaz amovible 110. Cela présente l'avantage de modifier aisément les caractéristiques d'écoulement du gaz.

Le module de distribution des gaz 100 est relié à des bouteilles de gaz positionnées à l'extérieur du réacteur. Une partie du module de distribution des gaz 100 est située de préférence au-dessus de la cavité résonante 41 et à proximité du module de couplage des ondes 80. Par « situé à proximité », il faut comprendre que le module de distribution des gaz 100 comprend des buses de distribution des gaz 113 pour l'injection des gaz dans la cavité résonante 41 situées à moins de 15 cm, de préférence à moins de 10 cm, de façon plus préférée à moins de 5 cm de la fenêtre diélectrique 82.

Le module de distribution des gaz 100 permet de mettre en oeuvre un procédé où les gaz sont injectés vers le support de croissance 51 à un débit total de gaz d'au moins 500 cm$^3$ par minute. Le module de distribution de gaz peut également permettre l'injection de dopant dans la cavité résonante 41. Ainsi, le module de distribution des gaz 100 peut permettre de mettre en oeuvre un procédé où les gaz comprennent au moins un dopant à une concentration égale ou supérieure à 0,01 ppm.

Dans un réacteur modulaire selon l'invention configuré pour opérer avec des microondes dont la fréquence est comprise entre 900 MHz et 1000 MHz, le débit du gaz injecté dans la cavité résonante 41 par le système d'arrivée des gaz 10 peut être d'au moins 500 cm$^3$ par minute, de préférence d'au moins 1 000 cm$^3$ par minute, de façon plus préférée d'au moins 5 000 cm$^3$ par minute.

Le module de distribution de gaz est de préférence proche d'un système de refroidissement comme par exemple celui de la partie centrale du guide d'onde.

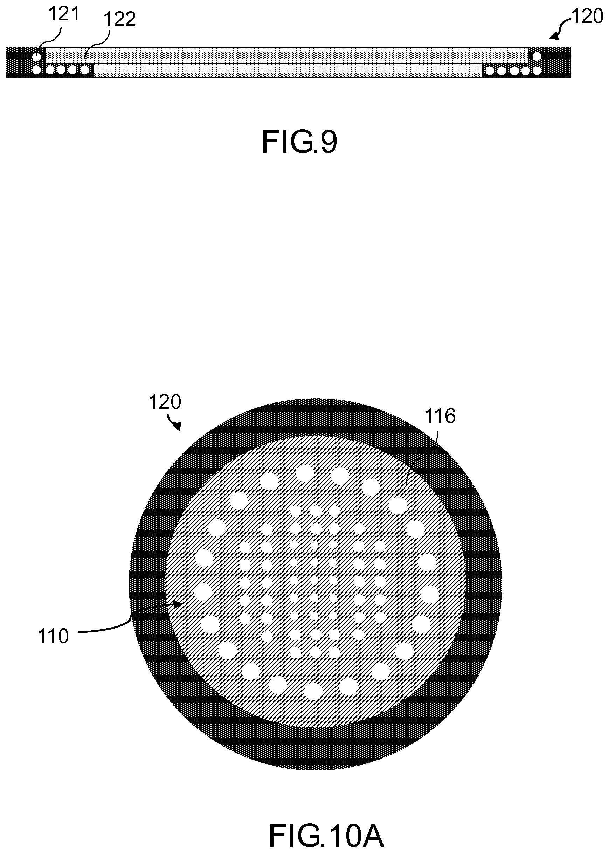

En outre, comme cela est présenté sur la **figure 9,** le **dispositif de support 120** peut comprendre au moins un canal 121 apte à faire circuler un fluide (e.g. un gaz ou un liquide) dans ledit dispositif de support 120. Cela permet un refroidissement par drain thermique de la plaque de distribution des gaz amovible 110. Le dispositif de support 120 peut également comprendre une surface de contact 122 adaptée pour recevoir la plaque de distribution des gaz amovible 110.

Le dispositif de support 120 peut contenir un ou plusieurs canaux 121. Par exemple, le dispositif de support 120 comprend un canal transversal positionné au niveau de l'emplacement destiné à accueillir la plaque distribution des gaz amovible 110. Le dispositif de support 120 peut comprendre plusieurs canaux 121 permettant, à débit identique, un refroidissement plus homogène.

Le ou les canaux 121 sont de préférence disposés à proximité de la surface de contact 122. Par « proximité » il faut comprendre au sens de l'invention à moins de 5 cm, de préférence à moins de 3 cm, de façon plus préférée à moins de 1 cm.

La surface de contact 122 du dispositif de support 120 présente de préférence une surface supérieure ou égale à 10 % de la surface dispositif de support 120 de façon à permettre un transfert thermique suffisant. Dans un réacteur modulaire selon l'invention configuré pour opérer avec des microondes dont la fréquence est comprise entre 900 MHz et 1000 MHz, la surface de contact 122 du dispositif de support 120 présente de préférence une surface supérieure à 50 cm$^2$ de façon à permettre un transfert thermique suffisant. La surface de contact 122 du dispositif de support 120 présente une surface, de façon plus préférée, supérieure à 60 cm$^2$ et de façon encore plus préférée, supérieure à 70 cm$^2$.

De façon avantageuse, la plaque de distribution des gaz amovible 110 comporte au moins une partie extrême 116 ne comprenant pas de buses de distribution des gaz 113 et cette partie extrême 116 est apte à être en contact avec le dispositif de support 120 sur une surface supérieure à 50 cm$^2$ de façon à améliorer le transfert thermique. De façon préférée, la partie extrême 116 ne comprenant pas de buses de distribution des gaz 113 est apte à être en contact avec le dispositif de support 120 sur une surface supérieure à 60 cm$^2$ et de façon encore plus préférée sur une surface supérieure à 70 cm$^2$.

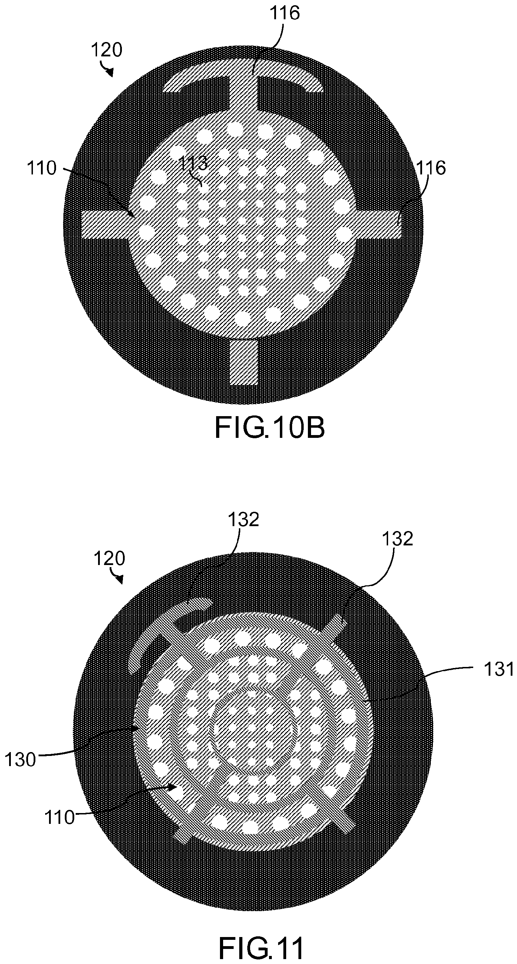

Comme cela est présenté sur la **figure 10A,** la partie extrême 116 peut consister en le pourtour de la plaque de distribution des gaz amovible 110. De façon alternative et comme présenté sur la **figure 10B,** la partie extrême 116 peut prendre différentes formes de façon à améliorer le transfert thermique.

Comme cela est présenté sur la **figure 11,** de façon avantageuse, le module de distribution des gaz 100 comporte **un organe de drain thermique 130** positionné au-dessus de la plaque de distribution des gaz amovible 110 et du dispositif de support 120. L'organe de drain thermique 130 peut présenter une surface d'acquisition de la chaleur 131 en contact avec la plaque de distribution des gaz amovible 110 représentant plus de 10 %, de préférence plus de 20 % de la surface de la plaque de distribution des gaz amovible 110, et une surface de distribution de la chaleur 132 en contact avec le dispositif de support 120 représentant plus de 10 %, de préférence plus de 20 % de la surface du dispositif 120. Dans un réacteur modulaire selon l'invention configuré pour opérer avec des microondes dont la fréquence est comprise entre 900 MHz et 1000 MHz, l'organe de drain thermique 130 peut présenter une surface d'acquisition de la chaleur 131 en contact avec la plaque de distribution des gaz amovible 110 supérieure à 20 cm$^2$, de façon préférée supérieure à 40 cm$^2$, de façon encore plus pré-

férée supérieure à 60 cm$^2$, et une surface de distribution de la chaleur 132 en contact avec le dispositif de support 120 supérieure à 10 cm$^2$, de façon préférée supérieure à 20 cm$^2$, de façon encore plus préférée supérieure à 50 cm$^2$.

En outre, le module de distribution des gaz 100 peut comporter un organe de maintien 140 configuré pour fixer la plaque de distribution des gaz amovible 110 au dispositif de support 120. Cet organe de maintien 140 peut par exemple comprendre un ressort, un mécanisme de clips, un crochet, une glissière, une encoche, une languette, des vis ou un ergot. De façon préférée, cet organe de maintien 140 peut être configuré de façon à compenser les différences de dilatation entre le dispositif support 120 et le système amovible. De façon préférée, cet organe de maintien 140 possède des propriétés d'élasticité et est configuré pour se placer à l'interface entre le dispositif support 120 et la plaque de distribution des gaz amovible 110.

La plaque de distribution des gaz amovible 110 est de préférence constituée d'aluminium, d'un alliage d'aluminium ou de cuivre, de façon plus préférée la plaque de distribution des gaz amovible 110 est constituée de cuivre.

Le dispositif de support 120 est de préférence constitué d'aluminium, d'un alliage d'aluminium ou de cuivre, de façon plus préférée le dispositif de support 120 est constitué de cuivre.

L'organe de drain thermique 130 est de préférence constitué d'aluminium, d'un alliage d'aluminium ou de cuivre, de façon plus préférée l'organe de drain thermique 130 est constitué de cuivre.

**Selon un autre aspect,** l'invention porte sur **un procédé de synthèse** de diamant mettant en oeuvre le réacteur modulaire selon l'invention.

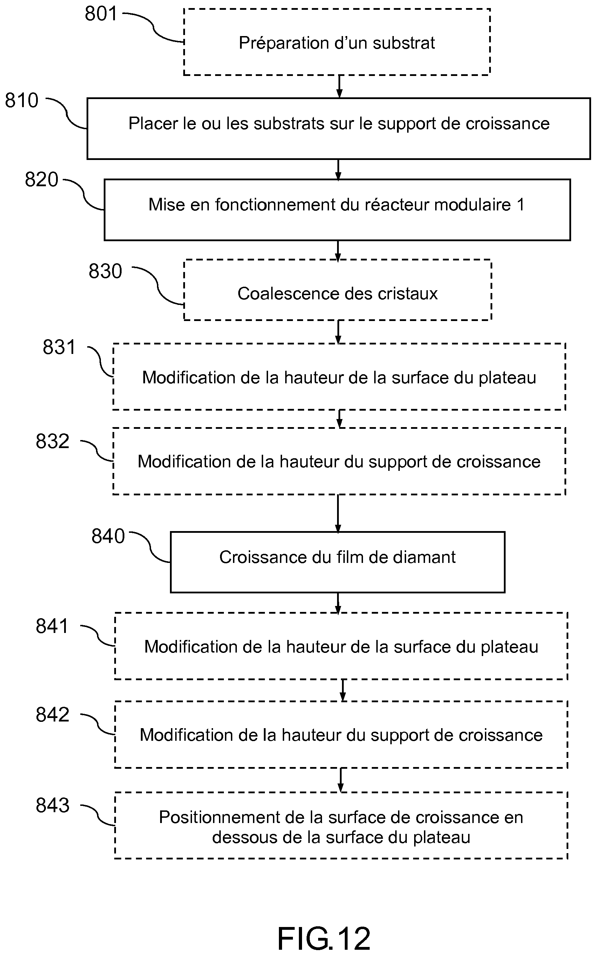

Le **procédé de synthèse 800** selon l'invention met de préférence en oeuvre le réacteur modulaire 1 selon l'invention. Il est présenté sur la **figure 12**. Le procédé de synthèse 800 comporte une **étape 810 consistant à placer le ou les substrats sur le support de croissance 51 du réacteur modulaire 1 selon l'invention.** Par exemple, il est possible d'utiliser une plaque de silicium, une plaque de métal (Mo, W, autre, ...) une plaque de diamant polycristallin, des monocristaux de diamant (naturels, issus d'un procédé haute pression-haute température (HPHT), issus d'un procédé CVD (chemical vapor déposition) utilisant l'invention du réacteur modulaire ou non, ou bien encore des monocristaux d'autres matériaux (métaux ou autre ..). La synthèse du diamant s'effectue de préférence sur un substrat de diamant monocristallin. Ainsi, le procédé de synthèse de diamant selon l'invention comporte de préférence une croissance homoépitaxique. Le substrat monocristallin peut présenter différentes formes et dimensions. Par exemple, il peut présenter une forme de cylindre, de cube, de parallélépipède, ou autre. Les dimensions peuvent par exemple varier de 100 micromètres à plusieurs millimètres de hauteur et de plusieurs millimètres, voire centimètres, de diamètre ou de côtés.

Le procédé de synthèse 800 selon l'invention peut comporter une **étape 801 de préparation du substrat.** Cette étape a pour objectif par exemple de réduire le nombre de dislocations à la surface des monocristaux. Un mode de réalisation pour cette étape est par exemple décrit dans le brevet FR3022563. Une étape 801 de préparation du ou des substrats peut être réalisée avant la mise en place du ou des substrats dans le réacteur 1 mais aussi après.

Le procédé de synthèse 800 selon l'invention comporte une **étape 820 de mise en fonctionnement du réacteur modulaire 1.** Cette étape a pour objectif :

- de générer une pression comprise entre 0,2 hPa et 500 hPa au sein de la cavité résonante 41,
- d'injecter des microondes, de préférence en mode de transmission TM$_{011}$, et à une puissance comprise par exemple entre 1 kW et 100 kW (ou plus), selon le type de générateur utilisé (fréquence utilisée),
- d'injecter des gaz, par exemple à un débit total d'au moins 500 cm$^3$ par minute, les gaz comprenant par exemple du méthane et du dihydrogène, et des additifs tels que oxygène, azote, bore, phosphore et argon, et
- de mettre en fonctionnement les systèmes de refroidissement de l'enceinte avec son système gaz de résistance thermique ainsi qu'un système de contrôle de refroidissement du substrat pour contrôler la température de la ou des surfaces de croissance, du système d'injection des gaz et du porte substrat.

Pour un réacteur 915 MHz, cela permet par exemple de délivrer sur la surface de croissance du substrat une densité de puissance surfacique d'au moins 0,5 W/mm$^2$, de préférence au moins 2 W/mm$^2$ et de façon encore plus préférée au moins 3 W/mm$^2$ de la surface de croissance du substrat. Généralement la densité de puissance est inférieure à 5 W/mm$^2$ à la surface de croissance du substrat. Cette étape permet de générer un plasma au-dessus de la surface de croissance du substrat et de permettre d'initier la croissance cristalline. En outre, la température du substrat est maintenue grâce aux systèmes de refroidissement à une température comprise par exemple entre 700°C et 1400°C., sauf dans le cas de croissance de diamant nano ou ultra-nanocristallin. Une description des différentes conditions de croissance peut être trouvée dans des ouvrages de référence (Derjaguin B. V., Journal of Crystal growth 31 (1975) 44-48 ; C. Wild et al, Diamond and Related Materials, 2 (1993) 158-168 ; Gicquel A et al. Current Applied Physics, vol1 Issue 6 , (2001) 479 ; Achard J et al, Journal of Crystal Growth 284 (2005) 396-405 ; Butler et al, J of physics-condensed Matter, vol 21, Issue 36 (2009) ; Silva et al, phys. stat. sol. (a) 203, No. 12, (2006) 3049-3055 ; Widman C, J et al Diamond & Related Materials 64 (2016) 1-7). La densité de puissance surfacique peut en outre être variée brutalement, par exemple par une variation de pression, pour assurer des variations brusques de composition ou de température du ou des substrats par exemple.

Pour la croissance de diamant polycristallin, le procédé de synthèse 800 selon l'invention peut comporter une **étape 830 de coalescence des cristaux.** Cette étape suit l'étape de nucléation du diamant à la surface du substrat (création de germes stables à la surface d'un matériau non diamant). Lors de cette étape, lorsque le réacteur modulaire 1 comporte un plateau 900 et/ou un module de porte substrat 500, le procédé peut comprendre une sous étape 831 de modification de la hauteur de la surface 910 du plateau 900 et/ou une sous étape 832 du support de croissance 51. Ces modifications de hauteur, rendues possible par la modularité du réacteur selon l'invention, permettent d'optimiser les paramètres de germination, coalescence et de croissance à savoir la température du substrat et/ou la densité surfacique de puissance au niveau de la surface de croissance du substrat et/ou l'incorporation renforcée ou diminuée de dopants. Par exemple lors de cette étape, le support de croissance 51 est positionné au-dessus de la surface 910 du plateau 900.

Cette procédure peut également être utilisée pour la croissance de diamant monocristallin.

Le procédé de synthèse 800 selon l'invention comporte une **étape 840 de croissance (épaississement/élargissement) du film de diamant.** Pour des films polycristallins, cette étape intervient après la coalescence des cristaux et la formation d'un film cristallin. Elle a pour objectif l'épaississement du film cristallin et l'amélioration de sa qualité cristalline. Lors de cette étape, lorsque le réacteur modulaire 1 comporte un plateau 900 et/ou un module de porte substrat 500, le procédé peut comprendre une sous étape 841 de modification de la hauteur de la surface 910 du plateau 900 et/ou 842 du support de croissance 51. Selon l'invention, grâce à la modularité du réacteur, une sous-étape de modification brutale de la température du substrat et / ou de la composition des gaz réactifs, tout comme des variables de pression et puissance peut également être appliquée. Les modifications de hauteur et/ou de conditions de croissance permettent d'optimiser les paramètres de croissance à savoir la température du substrat et/ou la densité de puissance au niveau de la surface de croissance du substrat et/ou l'incorporation en multicouches de dopants. Par exemple lors d'une sous étape 843, le support de croissance 51 pourrait être positionné même en dessous de la surface 910 du plateau 900. Ce dernier exemple pourrait être utilisé, par un choix judicieux des autres conditions de fonctionnement, pour « prédétacher » le film polycristallin de la surface non diamant sur laquelle le film a pris naissance. Une étape supplémentaire de reprise de croissance 844 pourrait alors être conduite à nouveau (support de croissance 51 au-dessus de la surface 910 du plateau 900) pour épaissir encore plus la couche en s'assurant une bonne maîtrise des conditions de croissance. Ceci est un exemple mettant en oeuvre la modularité de l'invention.

Les différentes modularités du réacteur peuvent également être utilisées pour l'épaississement de monocristaux de diamant.

En outre, lorsque le réacteur 1 modulaire selon l'invention comporte un module de distribution des gaz 100, le procédé de synthèse de diamant 800 peut comprendre une étape préalable de sélection et de positionnement d'une plaque de distribution des gaz amovible 110 en fonction des caractéristiques des couches de diamant souhaitées. En addition, pendant la croissance, le flux et la composition des gaz peuvent varier.

Lorsque le réacteur 1 modulaire selon l'invention comporte une couronne 450, le procédé de synthèse de diamant 800 peut comprendre une étape préalable de choix des dimensions de la couronne 450 en fonction des caractéristiques des couches de diamant souhaitées et de positionnement de la couronne 450 entre une première partie d'enceinte 430 et une deuxième partie d'enceinte 440 de façon à modifier la forme et/ou le volume de la cavité résonante 41.

Lorsque le réacteur 1 modulaire selon l'invention comporte un module de contrôle du refroidissement de substrat 300, le procédé de synthèse de diamant 800 peut comprendre une étape préalable de sélection et de positionnement d'un dispositif d'injection de gaz de résistance thermique amovible 330 en fonction des caractéristiques des couches de diamant souhaitées.

La mise en oeuvre du procédé selon l'invention permet l'obtention de couches de diamant répondant aux applications industrielles souhaitées dans une logique d'optimisation des coûts et de réduction du temps. Par exemple, il peut permettre la fabrication de couches de diamant d'une qualité supérieure à des conditions de croissance optimisées en termes de temps et de coût. Ainsi, **selon un autre aspect,** l'invention porte sur **des couches de diamant obtenues** à partir de la mise en oeuvre des réacteurs modulaires 1 selon l'invention et plus particulièrement à partir du procédé 800 selon l'invention.

**Selon un autre aspect,** l'invention porte sur certains des **modules** pouvant être intégrés au réacteur modulaire 1 selon l'invention.

Ainsi, l'invention porte sur un **module de porte substrat 500,** mobile en translation verticale et en rotation, en contact avec un quart d'onde 501 et comportant au moins un système de refroidissement fluide 520. Ce module de porte substrat 500 peut présenter toutes les caractéristiques optionnelles et/ou avantageuses décrites ci-dessus dans le cadre du réacteur modulaire 1. Ces caractéristiques optionnelles incluent par exemple un système d'isolation électrique du porte-substrat (e.g. un élément en PTFE ou autre isolant électrique).

L'invention porte également sur un **plateau 900 mobile** en translation verticale de façon à modifier la forme et le volume d'une cavité résonante 41 et comportant des ouvertures traversantes 911 permettant le passage des gaz. Ce plateau 900 peut présenter toutes les caractéristiques optionnelles et/ou avantageuses décrites ci-dessus dans le cadre du réacteur modulaire 1.

L'invention porte également sur une **couronne 450** apte à être positionnée entre une première partie d'enceinte 430 et une deuxième partie d'enceinte 440 de façon à modifier la forme et/ou le volume de la cavité résonante 41. Cette couronne 450 peut présenter toutes les caractéristiques optionnelles et/ou avantageuses décrites ci-dessus dans le cadre du réacteur modulaire 1. En outre, cette couronne 450 peut comprendre un système de joints 460.

L'invention porte également sur un **module de distribution des gaz 100,** comportant une plaque de distribution des gaz amovible 110 comprenant une surface interne 111, une surface externe 112 et une pluralité de buses de distribution des gaz 113 formant des canaux entre les dites surfaces 111, 112 aptes à conduire un flux de gaz, et un dispositif support 120 apte à accueillir la plaque de distribution des gaz amovible 110. Ce module de distribution des gaz 100 peut présenter toutes les caractéristiques optionnelles et/ou avantageuses décrites ci-dessus dans le cadre du réacteur modulaire 1.

L'invention porte également sur **une plaque de distribution des gaz amovible** 110 comprenant une surface interne 111, une surface externe 112 et une pluralité de buses de distribution des gaz 113 formant des canaux entre les dites surfaces 111, 112 aptes à conduire un flux de gaz. Cette plaque de distribution des gaz amovible 110 peut présenter toutes les caractéristiques optionnelles et/ou avantageuses décrites ci-dessus dans le cadre du réacteur modulaire 1.

L'invention porte également sur un **module de contrôle du refroidissement de substrat 300,** comportant un dispositif d'injection de gaz de résistance thermique amovible 330, ledit dispositif d'injection de gaz de résistance thermique amovible 330 comprend une ou plusieurs entrées de gaz de résistance thermique 333 et une ou plusieurs sorties de gaz de résistance thermique 331. Ce module de contrôle du refroidissement de substrat 300 peut présenter toutes les caractéristiques optionnelles et/ou avantageuses décrites ci-dessus dans le cadre du réacteur modulaire 1. L'invention est définie par les revendications.

## Revendications

1.  Réacteur modulaire de dépôt (1) assisté par plasma microonde pour la fabrication de diamant de synthèse, ledit réacteur comprenant :

    - un générateur de microonde (70) configuré pour générer des microondes dont la fréquence est comprise entre 300 MHz et 3000 MHz,
    - une cavité résonante (41) formée, au moins en partie, par les parois internes cylindriques (420) d'une enceinte du réacteur (400),
    - un système d'arrivée des gaz (10) apte à apporter des gaz au sein de la cavité résonante

    (41),
    - un module de sortie des gaz (60) apte à retirer lesdits gaz de la cavité résonante (41),
    - un module de couplage des ondes (80) apte à transférer les microondes depuis le générateur de microonde (70) jusqu'à la cavité résonante (41) de façon à permettre la formation d'un plasma, et
    - un support de croissance (51) présent dans la cavité résonante (41),

    ledit réacteur modulaire comprenant au moins trois éléments de modulation, lesdits éléments de modulation étant sélectionnés parmi :

    - une couronne (450) apte à être positionnée entre une première partie d'enceinte (430) et une deuxième partie d'enceinte (440) de façon à modifier la forme et/ou le volume de la cavité résonante (41), et un système de joints (460), permettant l'étanchéité du point de vue du vide et la continuité électrique des parois de l'enceinte, étant disposé entre la couronne (450) et respectivement, la première partie d'enceinte (430) et la deuxième partie (440) de l'enceinte (400) ;
    - un module de porte substrat (500) et un quart d'onde (501), ledit module de porte substrat étant mobile en translation verticale et en rotation, étant en contact avec le quart d'onde (501) et comportant au moins un système de refroidissement fluide (520) ;
    - un plateau (900) mobile en translation verticale de façon à modifier la forme et le volume de la cavité résonante (41) et comportant des ouvertures traversantes (911) permettant le passage des gaz ;
    - un module de distribution des gaz (100), comportant :

        ◦ une plaque de distribution des gaz amovible (110) comprenant une surface interne (111), une surface externe (112) et une pluralité de buses de distribution des gaz (113) formant des canaux entre les dites surfaces (111, 112) aptes à conduire un flux de gaz, et
        ◦ un dispositif de support (120) relié à un système de refroidissement et apte à accueillir la plaque de distribution des gaz amovible (110) ; et

    - un module de contrôle du refroidissement du substrat (300), comportant un dispositif d'injection de gaz de résistance thermique amovible (330), ledit dispositif d'injection de gaz de résistance thermique amovible (330) comprenant une ou plusieurs entrées de gaz de résistance thermique (333) et une ou plusieurs sorties de gaz de résistance thermique (331).

2. Réacteur selon la revendication 1, **caractérisé en ce qu'**il comprend au moins quatre éléments de modulation, lesdits éléments de modulation étant sélectionnés parmi :

- une couronne (450) apte à être positionnée entre une première partie d'enceinte (430) et une deuxième partie d'enceinte (440) de façon à modifier la forme et/ou le volume de la cavité résonante (41), et un système de joints (460), permettant l'étanchéité du point de vue du vide et la continuité électrique des parois de l'enceinte, étant disposé entre la couronne (450) et respectivement, la première partie d'enceinte (430) et la deuxième partie (440) de l'enceinte (400) ;
- un module de porte substrat (500) et un quart d'onde (501), ledit module de porte substrat étant mobile en translation verticale et en rotation, étant en contact avec le quart d'onde (501) et comportant au moins un système de refroidissement fluide (520) ;
- un plateau (900) mobile en translation verticale de façon à modifier la forme et le volume de la cavité résonante (41) et comportant des ouvertures traversantes (911) permettant le passage des gaz ;
- un module de distribution des gaz (100), comportant

  ○ une plaque de distribution des gaz amovible (110) comprenant une surface interne (111), une surface externe (112) et une pluralité de buses de distribution des gaz (113) formant des canaux entre les dites surfaces (111, 112) aptes à conduire un flux de gaz, et
  ○ un dispositif de support (120) relié à un système de refroidissement et apte à accueillir une plaque de distribution des gaz amovible (110) ; et

- un module de contrôle du refroidissement du substrat (300), comportant un dispositif d'injection de gaz de résistance thermique amovible (330), ledit dispositif d'injection de gaz de résistance thermique amovible (330) comprenant une ou plusieurs entrées de gaz de résistance thermique (333) et une ou plusieurs sorties de gaz de résistance thermique (331).

3. Réacteur selon l'une des revendications 1 ou 2, **caractérisé en ce qu'**il comprend au moins une couronne (450) apte à être positionnée entre une première partie d'enceinte (430) et une deuxième partie d'enceinte (440) de façon à modifier la forme et/ou le volume de la cavité résonante (41), et un système de joints (460), permettant l'étanchéité du point de vue du vide et la continuité électrique des parois de l'enceinte, étant disposé entre la couronne (450) et respectivement, la première partie d'enceinte (430) et la deuxième partie (440) de l'enceinte (400).

4. Réacteur selon l'une des revendications 1 à 3, **caractérisé en ce qu'**il comprend deux couronnes (450).

5. Réacteur selon l'une des revendications 1 à 4, **caractérisé en ce que** la ou les couronnes (450) présentent une hauteur comprise entre 1 cm et 20 cm.

6. Réacteur selon l'une des revendications 1 à 5, **caractérisé en ce que** la ou les couronnes (450) comportent un matériau diélectrique, un système d'injection de gaz ou sont constituées de métal avec un diamètre interne inférieur au diamètre interne de la cavité résonante (41).

7. Réacteur selon l'une des revendications 1 à 6, **caractérisé en ce qu'**il comprend un module de porte substrat (500) et un quart d'onde (501), ledit module de porte substrat étant mobile en translation verticale et en rotation, étant en contact avec le quart d'onde (501) et comportant au moins un système de refroidissement fluide (520).

8. Réacteur selon l'une des revendications 1 à 7, **caractérisé en ce que** le module de porte substrat (500) est isolé électriquement de l'enceinte (400) et/ou du plateau (900).

9. Réacteur selon l'une des revendications 1 à 8, **caractérisé en ce qu'**il comprend un plateau (900) mobile en translation verticale de façon à modifier la forme et le volume de la cavité résonante (41) et comportant des ouvertures traversantes (911) permettant le passage des gaz.

10. Réacteur selon l'une des revendications 1 à 9, **caractérisé en ce que** le plateau (900) comporte au moins un canal de refroidissement (930) relié à un système de refroidissement (940) et apte à refroidir ledit plateau (900).

11. Réacteur selon l'une des revendications 1 à 10, **caractérisé en ce qu'**il comprend un module de distribution des gaz (100), comportant :

- une plaque de distribution des gaz amovible (110) comprenant une surface interne (111), une surface externe (112) et une pluralité de buses de distribution des gaz (113) formant des canaux entre les dites surfaces (111, 112) aptes à conduire un flux de gaz, et
- un dispositif de support (120) relié à un système de refroidissement et apte à accueillir la plaque de distribution des gaz amovible (110).

12. Réacteur selon l'une des revendications 1 à 11, **caractérisé en ce que** le dispositif de support (120) comprend des canaux (121) aptes à faire circuler un gaz ou un liquide dans ledit dispositif de support (120).

13. Réacteur selon l'une des revendications 1 à 12, **caractérisé en ce que** la plaque de distribution des gaz amovible (110) comporte au moins une partie extrême (116) ne comprenant pas de buses de distribution (113) et étant apte à être en contact avec le dispositif de support (120) sur une surface supérieure ou égale à 10 % de la surface de la plaque de distribution des gaz amovible (110), de façon à améliorer le transfert thermique.

14. Réacteur selon l'une des revendications 1 à 13, **caractérisé en ce qu'**il comprend un module de contrôle du refroidissement du substrat (300), comportant un dispositif d'injection de gaz de résistance thermique amovible (330), ledit dispositif d'injection de gaz de résistance thermique amovible (330) comprenant une ou plusieurs entrées de gaz de résistance thermique (333) et une ou plusieurs sorties de gaz de résistance thermique (331).

15. Réacteur selon l'une des revendications 1 à 14, **caractérisé en ce que** le module de contrôle du refroidissement du substrat (300) comprend des moyens de positionnement (320) et **en ce que** le support de croissance (51) comporte, sur sa surface inférieure, des évidements aptes à accueillir les moyens de positionnement (320).

16. Réacteur selon l'une des revendications 1 à 15, **caractérisé en ce que** le module de contrôle du refroidissement du substrat (300) comprend des moyens de positionnement (320) mobiles en translation verticale.

17. Réacteur selon l'une des revendications 1 à 16, **caractérisé en ce que** le moyen de couplage des ondes (80) est situé dans la partie supérieure de la première partie de l'enceinte (430) et au moins à 25 cm du bas de la deuxième partie d'enceinte (440).

18. Procédé de synthèse de diamant mettant en oeuvre un réacteur de dépôt assisté par plasma microonde pour la fabrication de diamant de synthèse, ledit procédé comprenant les étapes suivante de :

   - placer (810) le ou les substrats sur le support de croissance (51) du réacteur modulaire (1) selon l'une quelconque des revendications précédentes,

- mettre en fonctionnement (820) le réacteur modulaire (1), la dite mise en fonctionnement comprenant les étapes suivantes :

   ◦ générer une pression comprise entre 0,2 hPa et 500 hPa au sein de la cavité résonante (41) fonctionnant en mode de transmission $TM_{011}$,
   ◦ injecter des microondes à une puissance comprise par exemple entre 1 kW et 100 kW,
   ◦ injecter des gaz, par exemple à un débit total d'au moins 500 $cm^3$ par minute, et
   ◦ mettre en fonctionnement des systèmes de refroidissement de l'enceinte, du système d'injection des gaz et du porte substrat, ainsi qu'un système de contrôle de refroidissement du substrat pour contrôler la température de la ou des surfaces de croissance, et

- réaliser une croissance (840) du film de diamant.

**Patentansprüche**

1. Modularer Reaktor für mikrowellenplasmaunterstützte Abscheidung (1) für die Herstellung von synthetischem Diamant, wobei der Reaktor umfasst:

   - einen Mikrowellengenerator (70), der zur Erzeugung von Mikrowellen mit einer Frequenz zwischen 300 MHz und 3000 MHz konfiguriert ist,
   - eine Resonanzkavität (41), die mindestens zum Teil von den zylindrischen Innenwänden (420) eines Behälters des Reaktors (400) gebildet ist,
   - ein Gaseinlasssystem (10), das imstande ist, Gase in die Resonanzkavität (41) zu befördern,
   - ein Gasauslassmodul (60), das imstande ist, die Gase aus der Resonanzkavität (41) abzuleiten,
   - ein Wellenkopplungsmodul (80), das imstande ist, die Mikrowellen vom Mikrowellengenerator (70) zur Resonanzkavität (41) weiterzuleiten, so dass die Bildung eines Plasmas gestattet wird, und
   - eine Wachstumsunterlage (51), die in der Resonanzkavität (41) vorhanden ist,

wobei der modulare Reaktor mindestens drei Modulationselemente umfasst, wobei die Modulationselemente ausgewählt sind aus:

   - einem Kranz (450), der imstande ist, zwischen einem ersten Behälterabschnitt (430) und einem zweiten Behälterabschnitt (440) derart positioniert zu sein, dass die Form und/oder das Volumen der Resonanzkavität (41) verändert werden, und ein Dichtungssystem (460), welches die Dichtigkeit im Hinblick auf das Vakuum und die elektrische Kontinuität der Wände des Behälters erlaubt, zwischen dem Kranz (450) und jeweils dem ersten Behälterabschnitt (430) und dem zweiten Abschnitt (440) des Behälters (400) angeordnet ist;

- einem Substratträgermodul (500) und einer Viertelwelle (501), wobei das Substratträgermodul, das vertikal translatorisch und rotatorisch beweglich ist, mit der Viertelwelle (501) im Kontakt ist und mindestens ein Fluidkühlsystem (520) aufweist;

- einer Platte (900), die derart vertikal translatorisch beweglich ist, dass die Form und das Volumen der Resonanzkavität (41) verändert werden und Durchgangsöffnungen (911) aufweist, die den Durchgang der Gase erlauben;

- einem Gasverteilungsmodul (100), aufweisend:

> ◦ eine lösbare Gasverteilerplatte (110), umfassend eine innere Fläche (111), eine äußere Fläche (112) und eine Vielzahl von Gasverteilerdüsen (113), die Kanäle zwischen den Flächen (111, 112) bilden, die imstande sind, einen Gasstrom zu führen, und
> ◦ eine Stützvorrichtung (120), die mit einem Kühlsystem verbunden ist und imstande, die lösbare Gasverteilerplatte (110) aufzunehmen; und

- einem Steuermodul der Kühlung des Substrats (300), aufweisend eine lösbare Einleitungsvorrichtung thermisch resistenter Gase (330), wobei die lösbare Einleitungsvorrichtung thermisch resistenter Gase (330) einen oder mehrere Einlässe thermisch resistenter Gase (333) und einen oder mehrere Auslässe thermisch resistenter Gase (331) aufweist.

2. Reaktor nach Anspruch 1, **dadurch gekennzeichnet, dass** er mindestens vier Modulationselemente umfasst, wobei die Modulationselemente ausgewählt sind aus:

> - einem Kranz (450), der imstande ist, zwischen einem ersten Behälterabschnitt (430) und einem zweiten Behälterabschnitt (440) derart positioniert zu sein, dass die Form und/oder das Volumen der Resonanzkavität (41) verändert werden, und ein Dichtungssystem (460), welches die Dichtigkeit im Hinblick auf das Vakuum und die elektrische Kontinuität der Wände des Behälters erlaubt, zwischen dem Kranz (450) und jeweils dem ersten Behälterabschnitt (430) und dem zweiten Abschnitt (440) des Behälters (400) angeordnet ist;

- einem Substratträgermodul (500) und einer Viertelwelle (501), wobei das Substratträgermodul, das vertikal translatorisch und rotatorisch beweglich ist, mit der Viertelwelle (501) im Kontakt ist und mindestens ein Fluidkühlsystem (520) aufweist;

- einer Platte (900), die derart vertikal translatorisch beweglich ist, dass die Form und das Volumen der Resonanzkavität (41) verändert werden und Durchgangsöffnungen (911) aufweist, die den Durchgang der Gase erlauben;

- einem Gasverteilungsmodul (100), aufweisend:

> ◦ eine lösbare Gasverteilerplatte (110), umfassend eine innere Fläche (111), eine äußere Fläche (112) und eine Vielzahl von Gasverteilerdüsen (113), die Kanäle zwischen den Flächen (111, 112) bilden, die imstande sind, einen Gasstrom zu führen, und
> ◦ eine Stützvorrichtung (120), die mit einem Kühlsystem verbunden ist und imstande, die lösbare Gasverteilerplatte (110) aufzunehmen; und

- einem Steuermodul der Kühlung des Substrats (300), aufweisend eine lösbare Einleitungsvorrichtung thermisch resistenter Gase (330), wobei die lösbare Einleitungsvorrichtung thermisch resistenter Gase (330) einen oder mehrere Einlässe thermisch resistenter Gase (333) und einen oder mehrere Auslässe thermisch resistenter Gase (331) aufweist.

3. Reaktor nach einem der Ansprüche 1 oder 2, **dadurch gekennzeichnet, dass** er mindestens einen Kranz (450) umfasst, der imstande ist, zwischen einem ersten Behälterabschnitt (430) und einem zweiten Behälterabschnitt (440) derart positioniert zu sein, dass die Form und/oder das Volumen der Resonanzkavität (41) verändert werden, und ein Dichtungssystem (460), welches die Dichtigkeit im Hinblick auf das Vakuum und die elektrische Kontinuität der Wände des Behälters erlaubt, zwischen dem Kranz (450) und jeweils dem ersten Behälterabschnitt (430) und dem zweiten Abschnitt (440) des Behälters (400) angeordnet ist.

4. Reaktor nach einem der Ansprüche 1 bis 3, **dadurch gekennzeichnet, dass** er zwei Kränze (450) umfasst.

5. Reaktor nach einem der Ansprüche 1 bis 4, **dadurch**

**gekennzeichnet, dass** der oder die Kränze (450) eine Höhe aufweisen, die zwischen 1 cm und 20 cm liegt.

6. Reaktor nach einem der Ansprüche 1 bis 5, **dadurch gekennzeichnet, dass** der oder die Kränze (450) ein dielektrisches Material, ein Gaseinleitungssystem aufweisen oder aus Metall mit einem Innendurchmesser bestehen, der kleiner als der Innendurchmesser der Resonanzkavität (41) ist.

7. Reaktor nach einem der Ansprüche 1 bis 6, **dadurch gekennzeichnet, dass** er ein Substratträgermodul (500) und eine Viertelwelle (501) umfasst, wobei das Substratträgermodul, das vertikal translatorisch und rotatorisch beweglich ist, mit der Viertelwelle (501) im Kontakt ist und mindestens ein Fluidkühlsystem (520) aufweist.

8. Reaktor nach einem der Ansprüche 1 bis 7, **dadurch gekennzeichnet, dass** das Substratträgermodul (500) vom Behälter (400) und/oder von der Platte (900) elektrisch isoliert ist.

9. Reaktor nach einem der Ansprüche 1 bis 8, **dadurch gekennzeichnet, dass** er eine Platte (900) umfasst, die derart vertikal translatorisch beweglich ist, dass die Form und das Volumen der Resonanzkavität (41) verändert werden und Durchgangsöffnungen (911) aufweist, die den Durchgang der Gase erlauben.

10. Reaktor nach einem der Ansprüche 1 bis 9, **dadurch gekennzeichnet, dass** die Platte (900) mindestens einen Kühlkanal (930) aufweist, der mit einem Kühlsystem (940) verbunden ist und imstande, die Platte (900) zu kühlen.

11. Reaktor nach einem der Ansprüche 1 bis 10, **dadurch gekennzeichnet, dass** er ein Gasverteilungsmodul (100) umfasst, aufweisend:

    - eine lösbare Gasverteilerplatte (110), umfassend eine innere Fläche (111), eine äußere Fläche (112) und eine Vielzahl von Gasverteilerdüsen (113), die Kanäle zwischen den Flächen (111, 112) bilden, die imstande sind, einen Gasstrom zu führen, und
    - eine Stützvorrichtung (120), die mit einem Kühlsystem verbunden ist und imstande, die lösbare Gasverteilerplatte (110) aufzunehmen.

12. Reaktor nach einem der Ansprüche 1 bis 11, **dadurch gekennzeichnet, dass** die Stützvorrichtung (120) Kanäle (121) umfasst, die imstande sind, ein Gas oder eine Flüssigkeit in der Stützvorrichtung (120) zirkulieren zu lassen.

13. Reaktor nach einem der Ansprüche 1 bis 12, **dadurch gekennzeichnet, dass** die lösbare Gasverteilerplatte (110) mindestens einen Endabschnitt (116) aufweist, der keine Verteilerdüsen (113) umfasst und imstande ist, mit der Stützvorrichtung (120) auf einer Fläche im Kontakt zu sein, die größer als oder gleich 10 % der Fläche der lösbaren Gasverteilerplatte (110) ist, so dass der thermische Transfer verbessert wird.

14. Reaktor nach einem der Ansprüche 1 bis 13, **dadurch gekennzeichnet, dass** er ein Steuermodul der Kühlung des Substrats (300) umfasst, aufweisend eine lösbare Einleitungsvorrichtung thermisch resistenter Gase (330), wobei die lösbare Einleitungsvorrichtung thermisch resistenter Gase (330) einen oder mehrere Einlässe thermisch resistenter Gase (333) und einen oder mehrere Auslässe thermisch resistenter Gase (331) aufweist.

15. Reaktor nach einem der Ansprüche 1 bis 14, **dadurch gekennzeichnet, dass** das Steuermodul der Kühlung des Substrats (300) Positionierungsmittel (320) umfasst und dass die Wachstumsunterlage (51) auf ihrer unteren Fläche Aussparungen aufweist, die imstande sind, die Positionierungsmittel (320) aufzunehmen.

16. Reaktor nach einem der Ansprüche 1 bis 15, **dadurch gekennzeichnet, dass** das Steuermodul der Kühlung des Substrats (300) vertikal translatorisch bewegliche Positionierungsmittel (320) umfasst.

17. Reaktor nach einem der Ansprüche 1 bis 16, **dadurch gekennzeichnet, dass** sich das Wellenkopplungsmodul (80) im oberen Abschnitt des ersten Abschnitts des Behälters (430) und mindestens 25 cm von unten des zweiten Behälterabschnitts (440) befindet.

18. Verfahren zur Diamantsynthese, bei dem ein Reaktor für mikrowellenplasmaunterstützte Abscheidung für die Herstellung von synthetischem Diamant zum Einsatz kommt, wobei das Verfahren die folgenden Schritte umfasst:

    - Platzieren (810) des oder der Substrate auf die Wachstumsunterlage (51) des modularen Reaktors (1) nach einem der vorangehenden Ansprüche,
    - Inbetriebsetzen (820) des modularen Reaktors (1), wobei das Inbetriebsetzen die folgenden Schritte umfasst:

        ∘ Erzeugen eines Drucks, der zwischen 0,2 hPa und 500 hPa liegt, innerhalb der Resonanzkavität (41), die im Transmissionsmodus $TM_{011}$ arbeitet,
        ∘ Einleiten der Mikrowellen mit einer Leistung, die beispielsweise bei einer Leistung zwischen 1 kW und 100 kW liegt,

∘ Einleiten der Gase, beispielsweise in einer Gesamtmenge von mindestens 500 cm$^3$ je Minute, und

∘ Inbetriebnehmen der Kühlsysteme des Behälters, des Gaseinleitungssystems und des Substratträgers sowie eines Steuerungssystems der Kühlung des Substrats, um die Temperatur der Wachstumsfläche(n) zu steuern, und

- Durchführen eines Wachstums (840) des Diamantfilms.

**Claims**

1. A modular microwave plasma-assisted deposition reactor (1) for manufacturing synthetic diamond, said reactor comprising:

   - a microwave generator (70) configured to generate microwaves having a frequency comprised between 300 MHz and 3000 MHz,
   - a resonant cavity (41) formed, at least partly, by the inner cylindrical walls (420) of an enclosure (400) of the reactor,
   - a gas inlet system (10) able to supply gases within the resonant cavity (41),
   - a gas outlet module (60) able to remove said gases from the resonant cavity (41),
   - a wave-coupling module (80) able to transfer the microwaves from the microwave generator (70) up to the resonant cavity (41) so as to allow the formation of a plasma, and
   - a growth support (51) present in the resonant cavity (41),

   said modular reactor comprising at least three modulation elements, said modulation elements being selected among:

   - a ring (450) able to be positioned between a first enclosure part (430) and a second enclosure part (440) so as to modify the shape and/or volume of the resonant cavity (41), and a seal system (460), allowing the sealing in terms of vacuum and the electrical continuity of the walls of the enclosure, being disposed between the ring (450) and respectively, the first part (430) and the second part (440) of the enclosure (400);
   - a substrate-holder module (500) and a quarter wave (501), said substrate-holder module being movable in vertical translation and in rotation, being in contact with the quarter wave (501) and including at least one fluid cooling system (520);
   - a platen (900) movable in vertical translation so as to modify the shape and volume of the resonant cavity (41) and including through-apertures (911) for the passage of the gases;
- a gas-distribution module (100), including:

   ∘ a removable gas-distribution plate (110) comprising an inner surface (111), an outer surface (112) and a plurality of gas-distribution nozzles (113) forming channels between said surfaces (111, 112) able to conduct a gas flow, and
   ∘ a support device (120) connected to a cooling system and able to accommodate the removable gas-distribution plate (110); and

- a substrate-cooling control module (300), including a removable device (330) for injecting thermal resistance gas, said removable device (330) for injecting thermal resistance gas comprising one or several thermal resistance gas inlet(s) (333) and one or several thermal resistance gas outlet(s) (331).

2. The reactor according to claim 1, **characterized in that** it comprises at least four modulation elements, said modulation elements being selected among:

   - a ring (450) able to be positioned between a first enclosure part (430) and a second enclosure part (440) so as to modify the shape and/or volume of the resonant cavity (41), and a seal system (460), allowing the sealing in terms of vacuum and the electrical continuity of the walls of the enclosure, being disposed between the ring (450) and respectively, the first part (430) and the second part (440) of the enclosure (400);
   - a substrate-holder module (500) and a quarter wave (501), said substrate-holder module being movable in vertical translation and in rotation, being in contact with the quarter wave (501) and including at least one fluid cooling system (520);
   - a platen (900) movable in vertical translation so as to modify the shape and the volume of the resonant cavity (41) and including through-apertures (911) for the passage of the gases;
   - a gas-distribution module (100), including:

      ∘ a removable gas-distribution plate (110) comprising an inner surface (111), an outer surface (112) and a plurality of gas-distribution nozzles (113) forming channels between said surfaces (111, 112) able to conduct a gas flow, and
      ∘ a support device (120) connected to a cooling system and able to accommodate the removable gas-distribution plate (110); and

   - a substrate-cooling control module (300), including a removable device (330) for injecting thermal resistance gas, said removable device (330) for injecting thermal resistance gas comprising one or several thermal resistance gas inlet(s) (333) and one or several thermal resistance gas outlet(s) (331).

3. The reactor according to any of claims 1 or 2, **characterized in that** it comprises at least one ring (450) able to be positioned between a first enclosure part (430) and a second enclosure part (440) so as to modify the shape and/or volume of the resonant cavity (41), and a seal system (460), allowing the sealing in terms of vacuum and the electrical continuity of the walls of the enclosure, being disposed between the ring (450) and respectively, the first part (430) and the second part (440) of the enclosure (400).

4. The reactor according to any of claims 1 to 3, **characterized in that** it comprises two rings (450).

5. The reactor according to any of claims 1 to 4, **characterized in that** the ring(s) (450) have a height comprised between 1 cm and 20 cm.

6. The reactor according to any of claims 1 to 5, **characterized in that** the ring(s) (450) include(s) a dielectric material, a gas-injection system or consist(s) of metal with an inner diameter smaller than the inner diameter of the resonant cavity (41).

7. The reactor according to any of claims 1 to 6, **characterized in that** it comprises a substrate-holder module (500) and a quarter wave (501), said substrate-holder module being movable in vertical translation and in rotation, being in contact with the quarter wave (501) and including at least one fluid cooling system (520).

8. The reactor according to any of claims 1 to 7, **characterized in that** the substrate-holder module (500) is electrically isolated from the enclosure (400) and/or from the platen (900).

9. The reactor according to any of claims 1 to 8, **characterized in that** it comprises a platen (900) movable in vertical translation so as to modify the shape and volume of the resonant cavity (41) and including through-apertures (911) for the passage of the gases.

10. The reactor according to any of claims 1 to 9, **characterized in that** the platen (900) includes at least one cooling channel (930) connected to a cooling system (940) and able to cool said platen (900).

11. The reactor according to any of claims 1 to 10, **characterized in that** it comprises a gas-distribution module (100), including:

- a removable gas-distribution plate (110) comprising an inner surface (111), an outer surface (112) and a plurality of gas-distribution nozzles (113) forming channels between said surfaces (111, 112) able to conduct a gas flow, and
- a support device (120) connected to a cooling system and able to accommodate the removable gas-distribution plate (110).

12. The reactor according to any of claims 1 to 11, **characterized in that** the support device (120) comprises channels (121) able to circulate a gas or a liquid in said support device (120).

13. The reactor according to any of claims 1 to 12, **characterized in that** the removable gas-distribution plate (110) includes at least one end part (116) that does not comprise distribution nozzles (113) and able to be in contact with the support device (120) on a surface greater than or equal to 10% of the surface of the removable gas-distribution plate (110) so as to improve the thermal transfer.

14. The reactor according to any of claims 1 to 13, **characterized in that** it comprises a substrate-cooling control module (300), including a removable device (330) for injecting thermal resistance gas, said removable device (330) for injecting thermal resistance gas comprising one or several thermal resistance gas inlet(s) (333) and one or several thermal resistance gas outlet(s) (331).

15. The reactor according to any of claims 1 to 14, **characterized in that** the substrate-cooling control module (300) comprises positioning means (320) and **in that** the growth support (51) includes, on its lower surface, recesses able to accommodate the positioning means (320).

16. The reactor according to any of claims 1 to 15, **characterized in that** the substrate-cooling control module (300) comprises positioning means (320) movable in vertical translation.

17. The reactor according to any of claims 1 to 16, **characterized in that** the wave-coupling means (80) is located in the upper part of the first enclosure part (430) and at least 25 cm from the bottom of the second enclosure part (440).

18. A diamond synthesis method implementing a microwave plasma-assisted deposition reactor for manufacturing synthetic diamond, said method comprising the following steps of:

- placing (810) the substrate(s) on the growth support (51) of the modular reactor (1) according to any one of the preceding claims,

- putting in operation (820) the modular reactor (1), said operation comprising the following steps:

  ∘ generating a pressure comprised between 0.2 hPa and 500 hPa within the resonant cavity (41) operating in transmission mode $TM_{011}$,
  ∘ injecting microwaves at a power comprised, for example, between 1 kW and 100 kW,
  ∘ injecting gases, for example at a total flow rate of at least 500 cm$^3$ per minute, and
  ∘ putting in operation systems for cooling the enclosure, the gas-injection system and the substrate-holder, as well as a system for controlling the cooling of the substrate to control the temperature of the growth surface(s), and

- performing a growth (840) of the diamond film.

**FIG.1**

FIG.2

FIG.3A

FIG.3B

FIG.3C

FIG.4

FIG.5A

FIG.5B

FIG.6A

FIG.6B

FIG.7

FIG.8

FIG.9

FIG.10A

FIG.10B

FIG.11

801 — Préparation d'un substrat

810 — Placer le ou les substrats sur le support de croissance

820 — Mise en fonctionnement du réacteur modulaire 1

830 — Coalescence des cristaux

831 — Modification de la hauteur de la surface du plateau

832 — Modification de la hauteur du support de croissance

840 — Croissance du film de diamant

841 — Modification de la hauteur de la surface du plateau

842 — Modification de la hauteur du support de croissance

843 — Positionnement de la surface de croissance en dessous de la surface du plateau

FIG.12

# EP 3 541 971 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2014220261 A
- US 2009239078 A
- US 8859058 B
- GB 2486783 A
- FR 3022563

**Littérature non-brevet citée dans la description**

- **KOBASHI et al.** *Diamond and Related Materials,* 2003, vol. 12, 233-240
- **ANDO Y et al.** *Diamond and Related Materials,* 2002, vol. 11, 596-600
- **MESBAHI et al.** *Journal of Applied Physics 2013,* 2013, vol. 46 (38
- **GICQUEL et al.** *Diamond and Related Materials,* 1994, vol. 3 (4-6), 581
- **GICQUEL et al.** *Current Applied Physics,* 2001, vol. 1 (6), 479
- **HASSOUNI et al.** *Journal of Applied Physics,* 1999, vol. 86 (1), 134
- **HASSOUNI et al.** *Journal of Physics D Journal of Applied Physics,* 2010, vol. 43 (15
- **GOODWIN et al.** *J. Appl. Phys.,* 1993, vol. 74 (11
- **MANKELEVICH et al.** *Journal Of Applied Physics,* 2008, 104
- **A. GICQUEL ; M. CHENNEVIER ; M. LEFEBVRE.** Chap. vol. 19, 739-796
- Handbook of industrial diamond and diamond films. Marcel Dekker, 1998
- **SILVA et al.** Microwave engineering of plasma -assisted CVD reactors for diamond déposition. *Journal of Physics: Condensed Matter,* 2009
- **J. ASMUSSEN.** High density plasma sources. Noyés publications, 1995
- **KUDELA TEREBESSY et al.** *Applied Physics Letter,* 2002, vol. 80 (7
- **D G GOODWIN.** *J. Appl. Phys.,* 1993, 74-11
- **H. YAMADA et al.** *DRM,* 2008, 17
- **X. LI et al.** *Physics procedia,* 2011, 22
- **J. WENG et al.** *DRM,* 2012, vol. 30
- **YUTAKA ANDO et al.** *DRM,* 2002, 11
- **TAKESHI TACHIBANAA et al.** *Diamond and Related Materials,* 2001, 10
- **DERJAGUIN B. V.** *Journal of Crystal growth,* 1975, vol. 31, 44-48
- **C. WILD et al.** *Diamond and Related Materials,* 1993, vol. 2, 158-168
- **GICQUEL A et al.** *Current Applied Physics,* 2001, vol. 1 (6), 479
- **ACHARD J et al.** *Journal of Crystal Growth,* 2005, vol. 284, 396-405
- **BUTLER et al.** *J of physics-condensed Matter,* 2009, vol. 21 (36
- **SILVA et al.** *phys. stat. sol.,* 2006, vol. 203 (12), 3049-3055
- **WIDMAN C, J et al.** *Diamond & Related Materials,* 2016, vol. 64, 1-7